Europäisches Patentamt

European Patent Office

Office européen des brevets

(19)

(11) Numéro de publication: **0 033 673**
**B1**

(12) # FASCICULE DE BREVET EUROPEEN

(45) Date de publication du fascicule du brevet:
**25.04.84**

(51) Int. Cl.³: **G 11 C 7/00,** G 06 F 13/00,
G 11 C 11/24

(21) Numéro de dépôt: **81400043.6**

(22) Date de dépôt: **14.01.81**

(54) **Procédé de rafraîchissement pour banc de mémoire à circuit "MOS" et séquenceur correspondant.**

(30) Priorité: **17.01.80 FR 8001031**

(43) Date de publication de la demande:
**12.08.81 Bulletin 81/32**

(45) Mention de la délivrance du brevet:
**25.04.84 Bulletin 84/17**

(84) Etats contractants désignés:
**DE FR IT**

(56) Documents cités:
FR - A - 2 431 749
US - A - 3 737 879
US - A - 3 790 961
US - A - 3 800 295
US - A - 3 811 117
US - A - 4 040 122
US - A - 4 106 108
US - A - 4 133 051
US - A - 4 158 883
US - A - 4 172 282

ELECTRONIC DESIGN, vol. 26, no. 26, 20 décembre
1978, NEW YORK (US) Mc CORMICK: "Take the
'Dynamics' out of dynamic RAM with an IC controller
handling refresh", pages 72-76
ELECTRONICS, vol. 52, no. 4, 15 février 1979, NEW

(73) Titulaire: **COMPAGNIE INTERNATIONALE POUR
L'INFORMATIQUE CII - HONEYWELL BULL (dite
CII-HB), 94, avenue Gambetta, F-75020 Paris (FR)**

(72) Inventeur: **Girard, Paul, 1, rue Isaac Albeniz,
F-91440 Bures sur Yvette (FR)**

(74) Mandataire: **Doireau, Marc et al, CII-Honeywell Bull
Division Propriété Industrielle 94, avenue Gambetta
Boîte Postale 33, F-75960 Paris cedex 20 (FR)**

(56) Documents cités: (suite)
YORK (US) FORD et al.: "64-K Dynamic RAM has pin
that refreshes", pages 141-147
SEMICONDUCTOR MEMORY HANDBOOK, INTEL,
Editeur Wiley 1978 NEW YORK (US) FIELLAND:
"Dynamic RAM's used with microprocessors", pages
139 à 181
ELECTRONIC DESIGN, vol 27, no. 13, 21 juin 1979, NEW
YORK (US) YOUNG: "64-K RAM with single supply could
be the standard for future design", pages 58-64

EP 0 033 673 B1

## Procede de rafraîchissement pour banc de memoire a circuit »MOS« et sequenceur correspondant

La présente invention concerne un procédé de rafraîchissement d'un banc de mémoire à cellules capacitives, ou circuits »MOS«, et le séquenceur de rafraîchissement correspondant applicables aux systèmes de traitement de l'information.

Les circuits »MOS« (abréviation du terme anglo-saxon »Metal Oxyde Semi-conductor«) sont des dispositifs de mémorisation qui emmagasinent l'information sous la forme d'une quantité d'électricité stockée dans un condensateur de très faible capacité. Ce condensateur ayant une résistance de fuite, il est nécessaire de lui adjoindre un dispositif pour le recharger périodiquement, afin de conserver l'information emmagasinée. Cette opération de recharge périodique porte le nom d'opération de rafraîchissement.

Au cours du rafraîchissement, le système de traitement de l'information n'a plus accès au banc de mémoire pour exécuter ses propres traitements. Le banc de mémoire est donc sollicité par deux types d'opérations dont l'exécution occupe des cycles du système: l'opération de rafraîchissement sera exécutée durant un cycle de rafraîchissement, alors que les opérations élémentaires de traitement s'exécuteront durant des cycles utiles. D'une façon générale, les demandes de cycles utiles et de rafraîchissement sont asynchrones, le système doit donc les resynchroniser afin de pouvoir les sélectionner.

Il est connu, d'une part, de faire suivre un cycle utile par un cycle de rafraîchissement et, d'autre part, de procéder à un cycle de rafraîchissement si un cycle utile n'est pas demandé, comme décrit aux pages 141 à 147 d'un article de FORD et al. paru dans la revue »ELECTRONICS« volume 52, n° 4 du 15 février 1979. Dans les systèmes de l'art antérieur, la décision de la sélection est nécessairement prévue au début de chaque cycle utile ou de rafraîchissement. Avec les technologies actuelles, le temps de décision est voisin d'une centaine de nanosecondes auquel s'ajoute une vingtaine de nanosecondes pour effectuer les opérations de commutation et de préparation des circuits d'adressage. Les blocs de mémoire sont donc indisponibles pour le système de traitement de l'information durant environ 120 nanosecondes, à chaque cycle, avant que soit lancé effectivement soit un cycle utile, soit un cycle de rafraîchissement. Ce phénomène est notamment plus aggravé lorsqu'il s'agit d'opération élémentaire de lecture d'une information dans un bloc mémoire, car le temps mis pour acquérir l'information, encore appelé temps d'accès à l'information, est systématiquement grevé par le temps de sélection.

La présente invention pallie ces inconvénients à l'aide d'un procédé et d'un dispositif dans lequel la durée des phases de sélection de l'information ne s'ajoute plus systématiquement à la durée d'un cycle, notamment en diminuant le temps d'accès à l'information de la durée nécessaire à sa sélection.

Pour atteindre ces objectifs, le procédé selon l'invention consiste à lancer simultanément les phases de sélection et d'exécution d'un cycle utile au début de chaque cycle, puis à arrêter à la fin de la phase de sélection l'exécution du cycle utile et à enchaîner sur la phase d'exécution d'un cycle de rafraîchissement si durant la phase de sélection une opération de rafraîchissement a été sélectionnée. Un autre but du procédé selon l'invention est de lancer simultanément les phases de sélection et d'exécution au début de chaque cycle utile, puis à exécuter le cycle utile, enfin à enchaîner sur a phase d'exécution d'un cycle de rafraîchissement si durant l'exécution du cycle utile, une opération de rafraîchissement a été sélectionnée.

Un autre but de l'invention est un dispositif séquenceur de rafraîchissement faisant application du procédé précédemment décrit.

L'invention sera mieux comprise à l'aide de la description faite au regard des dessins qui va suivre.

La figure 1 montre l'organisation d'un banc mémoire.

La figure 2 est une représentation du régulateur de commande de la figure 1.

La figure 3 est une représentation du registre d'assignation de la figure 1.

La figure 4 est une représentation du régulateur de rafraîchissement de la figure 1.

La figure 5 est une représentation du sous-ensemble de mémorisation de la figure 1.

La figure 6 montre un mode de réalisation du sélecteurlanceur de la figure 2.

La figure 7 montre de façon détaillée la constitution du générateur de rafraîchissement apparent de la figure 2.

La figure 8 est une représentation détaillée de l'excitateur de mémoire de la figure 2.

La figure 9 est une représentation du scripteur (ou excitateur d'écriture) de la figure 2.

La figure 10 montre le générateur de régulation d'écriture de la figure 2.

La figure 11 est une représentation du lecteur (ou excitateur de lecture) de la figure 2.

La figure 12 est une représentation du terminateur de cycle.

La figure 13 montre le générateur de commande d'assignation.

La figure 14 donne une représentation du registre d'adresse de la figure 3.

La figure 15 donne une représentation du registre de fonction de la figure 3.

La figure 16 représente l'excitateur de rafraîchissement de la figure 4.

La figure 17 représente le générateur de rafraîchissement masqué de la figure 4.

La figure 18 représente l'enregistreur de rafraîchissement masqué de la figure 4.

La figure 19 représente le compteur d'adresse de rafraîchissement de la figure 4.

La figure 20 représente le distributeur de commandes des zones de mémoire.

La figure 21 représente le sous-ensemble des zones de mémoire.

La figure 22 est un diagramme de répartition des temps de cycle de la technique antérieure.

La figure 23 est une représentation de la répartition des temps de cycle selon l'invention dans le cas d'une sélection binaire.

La figure 24 est un tableau de vérité définissant le mode de sélection ternaire.

La figure 25 est un diagramme représentant la répartition des temps de cycle dans le cas d'une sélection ternaire selon l'invention.

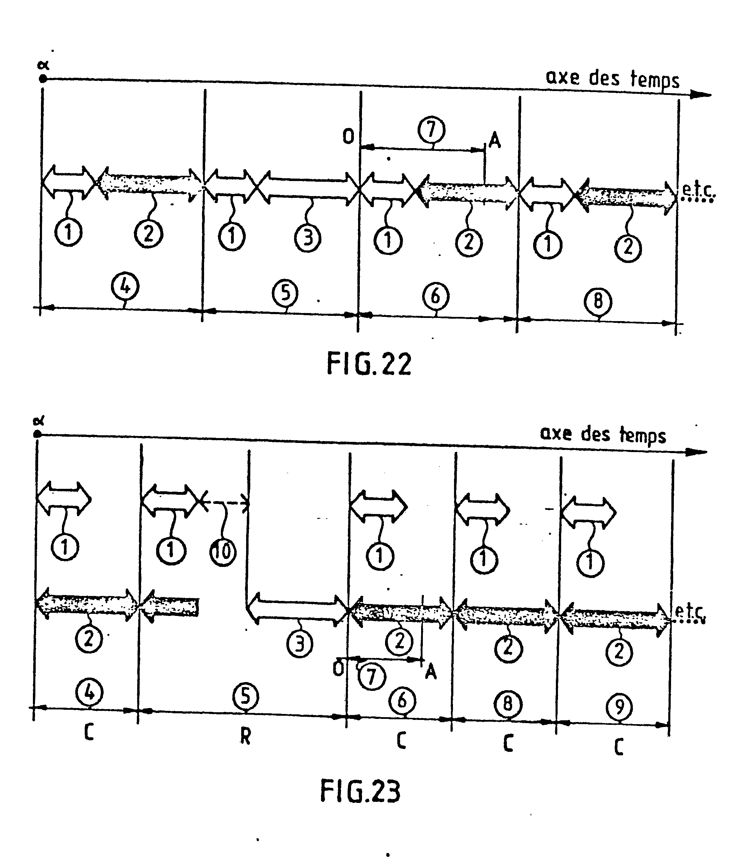

Les diagrammes des temps des figures 22, 23 et 25 et la figure 24 illustrent le principe général de l'invention.

Le diagramme de la figure 22 donne une répartition des cycles de la technique antérieure, et n'est montré que pour mieux faire apparaître par contraste les avantages apportés par le dispositif de l'invention. Cette figure représente une répartition dans le temps des cycles utiles et de rafraîchissement. Les graphes 4, 6 et 8 représentent des cycles utiles. Le graphe 5 représente un cycle de rafraîchissement. Chacun de ces cycles comporte un intervalle de temps 1 nécessaire aux opérations de sélection et un intervalle de temps 2 nécessaire à l'exécution. Le graphe 5 correspondant à un cycle de rafraîchissement est formée de la juxtaposition d'un intervalle de sélection 1 et d'un intervalle d'exécution de rafraîchissement 3. Le graphe 6 correspond à un cycle de lecture d'une information dans le banc de mémoire, l'intervalle OA (flèche 7) mesure le temps d'accès à l'information.

Dans cet exemple tiré de l'art antérieur, on remarque que les phases de sélection 1 s'ajoutent systématiquement à chaque temps de cycles, et que le temps d'accès à une information (flèche 7) est grevé du temps de sélection 1.

Comme exposé précédemment, le principe général de l'invention consiste à ne pas attendre le résultat de la phase de sélection, pour exécuter à priori une phase d'exécution de cycle utile.

Ceci apparaît sur la figure 23 donnant le diagramme des temps de cycles selon le principe de l'invention dans le cas de la »Sélection Binaire«. On dit que la »Sélection« est »Binaire« lorsque le choix en fin de sélection porte sur deux possibilités: on aura à exécuter soit un »cycle utile« (C), soit un »cycle de rafraîchissement« (R).

Pendant l'exécution des phases de sélection matérialisées par les graphes 1, les phases d'exécution des cycles utiles symbolisées par les graphes 2 sont lancées en parallèle dès le début de cycle et complètement effectuées toutes les fois que la sélection confirme la prise en compte d'un cycle utile. C'est le cas des cycles marqués 4, 6, 8 ou 9, notés aussi (C). Dans ces conditions, la longueur des cycles utiles étant nettement réduite, leur nombre par unité de temps s'accroît considérablement et ainsi le débit s'améliore notablement. Le léger accroissement analysé plus loin du temps de cycle de rafraîchissement n'a que peu d'effet contraire sur cette amélioration, étant donné que la proportion des cycles de rafraîchissement reste voisine de quelque pour cent par rapport au nombre total de cycles. De plus, cet inconvénient est totalement levé grâce à la »Sélection Ternaire« exposée plus loin. De même, le temps d'accès à l'information 7, porté par la flèche OA, est réduit de manière significative par rapport à celui obtenu avec les techniques connues.

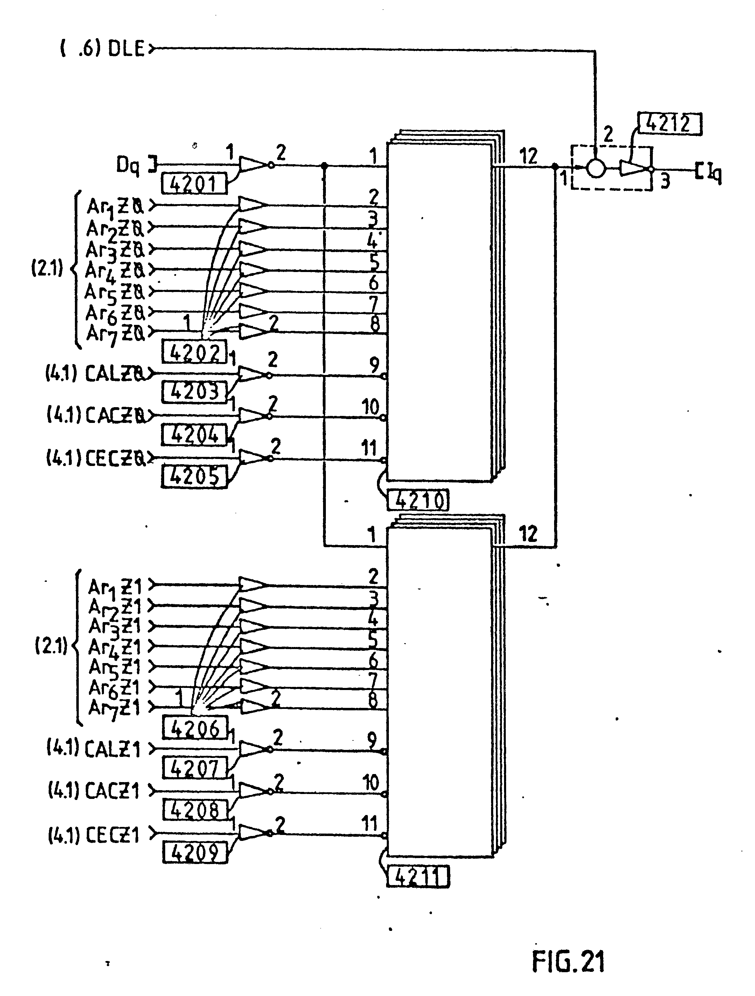

Dans le cas maintenant où, périodiquement, la sélection aboutit à la prise en compte d'un cycle de rafraîchissement, il faut achever au plus vite les actions technologiques lancées pour l'exécution d'un cycle utile sans manipulation effective de l'information. Ceci est imposé par la technologie des circuits »MOS«. Cette prolongation d'exécution d'un »cycle blanc« ainsi exécutée est matérialisée par la flèche en pointillé marquée 10 sur la figure 21. A l'issue de cette phase de cycle blanc d'achèvement des actions technologiques, la phase d'exécution d'un »cycle de rafraîchissement« (3) est mise en oeuvre, ce qui termine le »cycle de rafraîchissement« (R) noté 5.

Cependant, l'invention a été perfectionnée en créant l'opportunité d'une »Sélection Ternaire«. Au lieu de laisser le choix entre les seuls »cycle utile« (C) et »cycle de rafraîchissement« (R) définis par l'état binaire d'un seul basculeur, il a été introduit deux basculeurs définissant quatre états binaires, parmi lesquels trois possibilités ont été retenues.

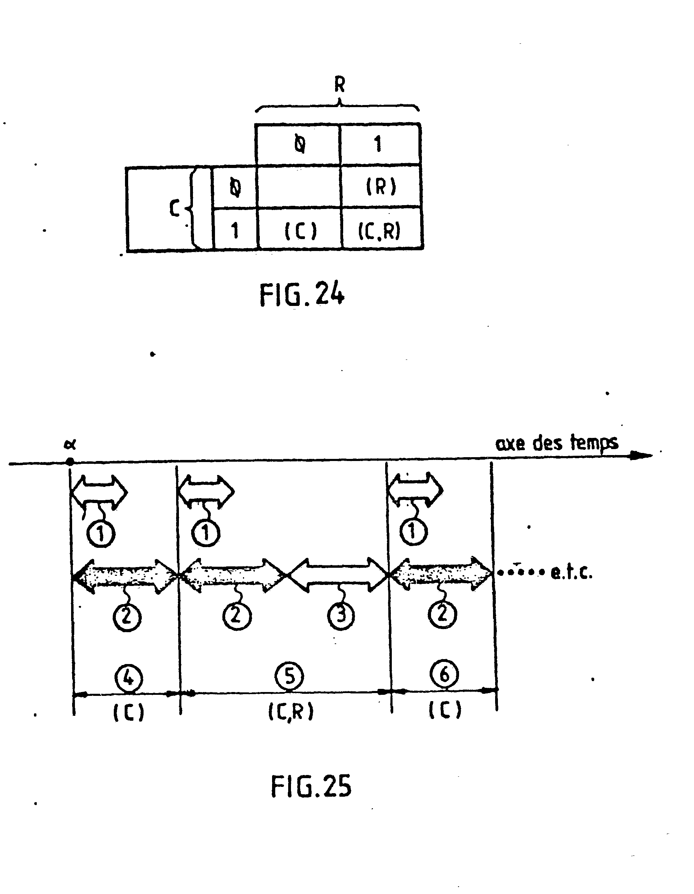

Le tableau de la figure 24 donne les éléments de choix en fonction de l'état des basculeurs et définit ainsi la Sélection Ternaire. Un des basculeurs noté C peut prendre les valeurs 0 et 1 auxquelles correspondent les lignes du tableau; l'autre basculeur noté R indice suivant sa valeur 0 ou 1 les colonnes du tableau. La configuration C à 0 et R à 0 n'est pas significative. Celle qui correspond à C à 1 et R à 0 indique par la lettre parenthésée (C) l'option d'un »cycle utile«. Celle pour laquelle C est à 0 et R à 1 est notée (R) pour l'option d'un »cycle de rafraîchissement«.

Enfin, celle pour laquelle C et R valent 1 tous les deux, symbolisée par (C, R) offre une nouvelle option qui se traduira par la commande enchaînée d'une phase d'exécution de »cycle utile« (C) suivie immédiatement d'une phase d'exécution de rafraîchissement (R). C'est cette dernière combinaison qui apparaît dans l'intervalle de temps noté 5 sur la figure 25 donnant le diagramme des temps de cycle selon le principe de l'invention dans le cas de la Sélection Ternaire. Les »cycles utiles« (C) tels que 4 ou 6 se déroulent de la même manière que précédemment dans le cas de la Sélection Binaire. De même, dans l'éventualité de l'option (R) correspondant à un cycle de rafraîchissement exclusif, la stratégie est celle déjà décrite pour le cycle de type 5 dans le cas de la Sélection Binaire (figure 23). Elle ne figure pas sur le diagramme de la figure 25; son apparition est en effet très improbable sauf si le banc de mémoire est très sousutilisé auquel cas la perte de débit n'a aucune importance.

Le cycle 5 exécuté à l'échéance de l'option (C, R) se déroule de la manière suivante:

— les phases de sélection et d'exécution de »cycle utile« représentées respectivement par les graphes 1 et 2 du cycle 5 sont lancées simultanément. A la fin de la phase d'exécution (graphe 2) on sait, depuis la fin de sélection (graphe 1), qu'un rafraîchissement a été sélectionné: on exécute donc une phase de rafraîchissement (graphe 3) avant de libérer les organes de commande pour un nouveau cycle. Dans ce dernier cas, finalement, la chute de débit se limite donc à la perte très faible du temps d'exécution de la seule phase de rafraîchissement (graphe 3). Ainsi avec la »Sélection Ternaire«, la réduction de la perte de temps due au rafraîchissement et par conséquent, l'amélioration du débit ont été encore augmentées.

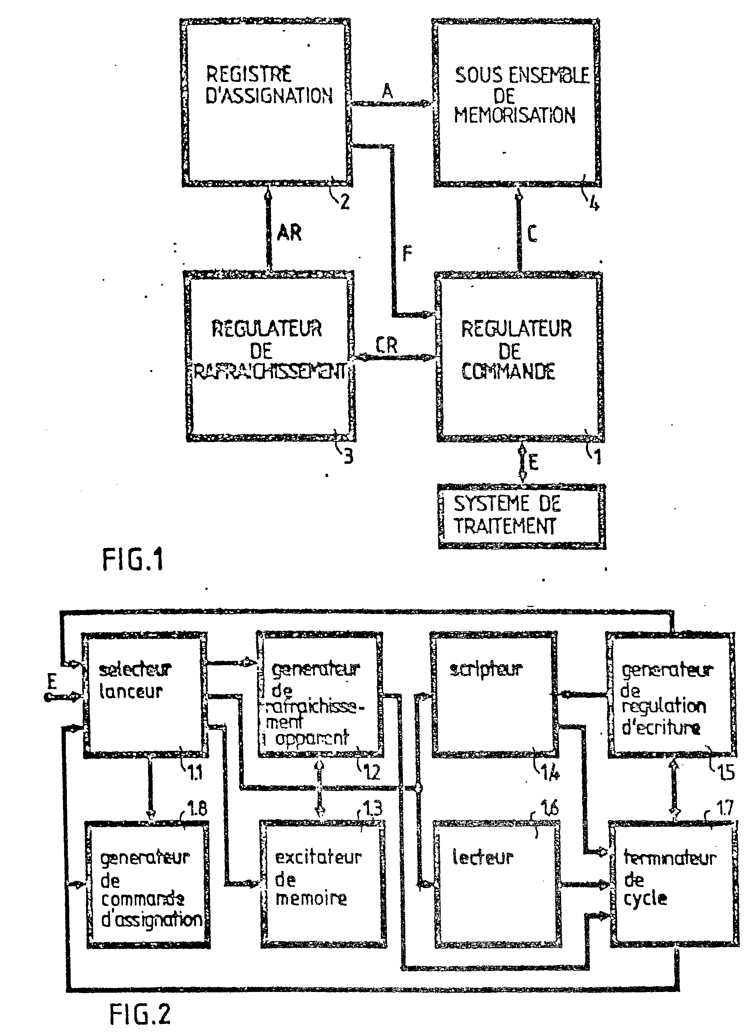

La figure 1 montre l'organisation d'un banc de mémoire. Le banc de mémoire se compose d'un régulateur de commande 1, d'un registre d'assignation 2, d'un régulateur de rafraîchissement 3 et d'un sous-ensemble de mémorisation 4. Le régulateur de commande 1 est en communication avec le reste du système de traitement de l'information non représenté ainsi qu'avec le sous-ensemble de mémorisation 4 en direction duquel il émet des signaux de commande C. Le registre d'assignation 2 communique l'adresse A d'un emplacement de mémoire à l'intérieur du sous-ensemble de mémorisation ainsi que la fonction F au régulateur de commande 1.

Le régulateur de rafraîchissement dialogue avec le régulateur de commande par échange de signaux CR et fournit les adresses AR des informations à rafraîchir au registre d'assignation.

Le régulateur de commande est représenté à la figure 2. Il comporte un sélecteur-lanceur 1.1, un générateur de rafraîchissement apparent 1.2, un excitateur de mémoire 1.3, un scripteur 1.4, un générateur de régulation d'écriture 1.5, un lecteur 1.6, un terminateur de cycle 1.7 et un générateur de commande d'assignation 1.8. Le sélecteur-lanceur 1.1 reçoit des demandes de cycles de mémoire provenant de l'extérieur du régulateur de commande et des demandes de rafraîchissement internes au banc de mémoire issues du régulateur de rafraîchissement. Il décide de l'exécution de ces demandes pour déclencher le fonctionnement soit du générateur de rafraîchissement apparent 1.2, soit du scripteur 1.4 ou du lecteur 1.6. Dans tous les cas, il intervient dans le fonctionnement du générateur de commande d'assignation 1.8 et de l'excitateur de mémoire 1.3. Le générateur de rafraîchissement apparent 1.2 a pour fonction de déclencher un cycle de rafraîchissement apparent, il communique avec l'excitateur de mémoire. Lorsqu'un cycle de rafraîchissement est terminé, le générateur de rafraîchissement apparent 1.2 commande le terminateur de fin de cycle 1.7.

L'excitateur de mémoire 1.3 emgendre des signaux de commande de déclenchement des cycles de mémoire dans le sous-ensemble de mémorisation 4 de la figure 1. Le scripteur 1.4 commande les actions d'écriture dans le sous-ensemble de mémorisation 4 en fonction d'ordre émis par le générateur de régulation d'écriture 1.5. Lorsque l'opération d'écriture est terminée, le scripteur 1.4 commande le terminateur de cycle 1.7. Le générateur de régulation d'écriture 1.5 dialogue avec le terminateur de cycle 1.7, supervise le scripteur 1.4 et commande le sélecteur-lanceur 1.1 pour la relance d'une phase de cycle de mémoire.

Le lecteur 1.6 déclenche les opérations de lecture dans le sous-ensemble de mémorisation 4 avant de commander à la fin du cycle de lecture le terminateur de cycle 1.7. Le terminateur de cycle 1.7 collecte les fins des diverses opérations s'exécutant dans le banc de mémoire, et autorise les nouvelles actions du sélecteur lanceur, c'est-à-dire de nouveaux cycles mémoire. Le générateur de commande d'assignation 1.8 commande sous le contrôle du sélecteur lanceur 1.1 et du terminateur de cycle 1.7 le registre d'assignation 2 de la figure 1.

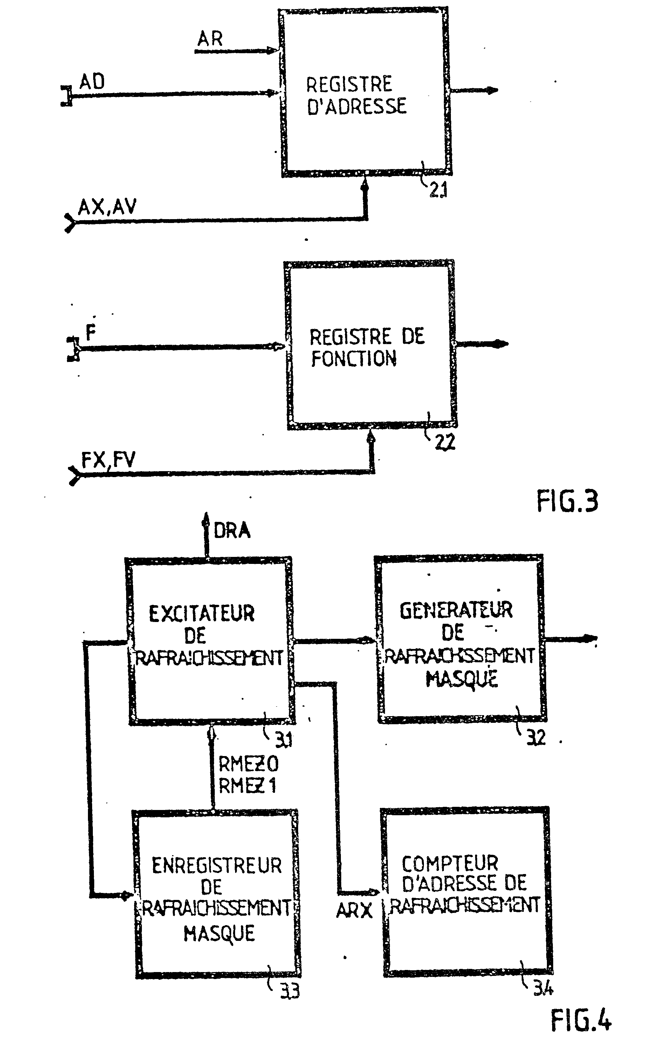

Le registre d'assignation représenté à la figure 3 se décompose en un registre d'adresse 2.1 et un registre de fonction 2.2. Le registre d'adresse 2.1 reçoit l'adresse AD de l'emplacement de mémoire recherchée et d'autre part l'adresse de rafraîchissement AR engendrée par le régulateur de rafraîchissement. Ces adresses sont enregistrées à l'intérieur du registre 2.1 pour être présentées au sous-ensemble de mémorisation sous le contrôle des signaux de commande AX, AV émis par le générateur de commande d'assignation 1.8. Le registre de fonction 2.2 enregistre la fonction F qui doit être exécutée par l'organe régulateur de commande, sous le contrôle des signaux de commande FX, FV engendrés par le générateur de commande d'assignation.

Comme indiqué à la figure 4, le régulateur de rafraîchissement se décompose en un excitateur de rafraîchissement 3.1, un générateur de rafraîchissement masqué 3.2, un enregistreur de rafraîchissement masqué 3.3, et un compteur d'adresse de rafraîchissement 3.4. L'excitateur de rafraîchissement décide du lancement des appels de rafraîchissement masqué vers le générateur de rafraîchissement masqué 3.2 et de la demande de rafraîchissement apparent DRA émise vers le sélecteur lanceur 1.1, lorsque les résultats RMEZ0 et RMEZ1 fournis par l'enregistreur de rafraîchissement masqué ne sont pas satisfaisants, ces opérations ayant lieu cycliquement. Le générateur de rafraîchissement masqué 3.2 commande l'exécution des cycles de rafraîchissement masqué dans le sous-ensemble de mémorisation 4. L'enregistreur de rafraîchissement masqué 3.3 reçoit du système de régulation du banc de mémoire les indications d'exécution des cycles de rafraîchissement masqué. Il les mémorise pour les communiquer à l'excitateur de rafraîchissement 3.1 sous les appellations RMEZ0 et RMEZ1. Le compteur d'adresse de rafraîchissement 3.4 fournit l'adresse de rafraîchissement AR au registre d'adresse du sous-ensemble de mémorisation 4, sous le contrôle du signal de progression ARX issu de l'excitateur de rafraîchissement 3.1.

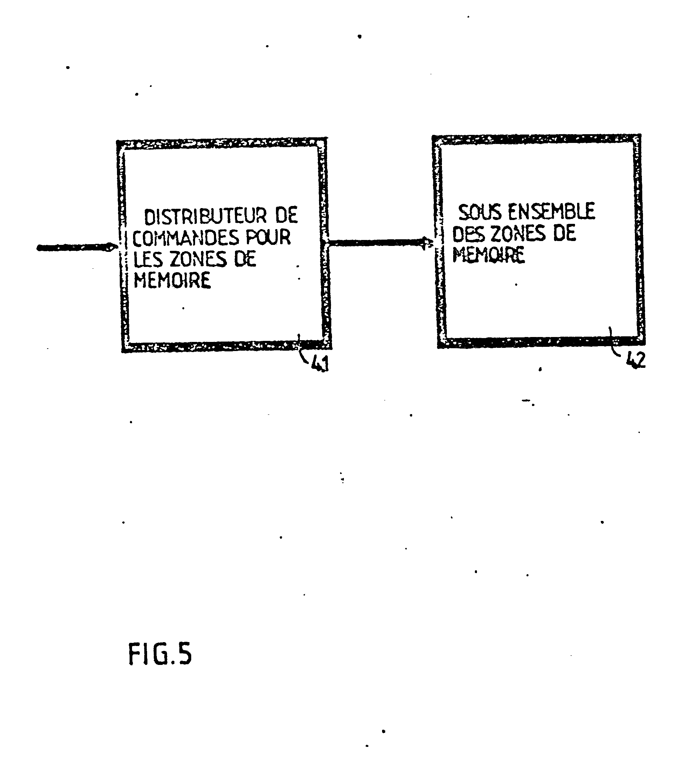

Le sous-ensemble de mémorisation représenté à la figure 5 comprend un distributeur de commandes pour les zones de mémoire 4.1 et un sous-ensemble des zones de mémoire 4.2. Le distributeur de commandes dirige les signaux de commande de mémoire issus du système de régulation dans deux partitions de mémoire qui constituent le sous-ensemble des zones de mémoire. Le sous-ensemble des zones de mémoire contient les cellules de mémorisation ou points de mémoire dont la réalisation est effectuée à l'aide de condensateurs intégrés en technologie »MOS«.

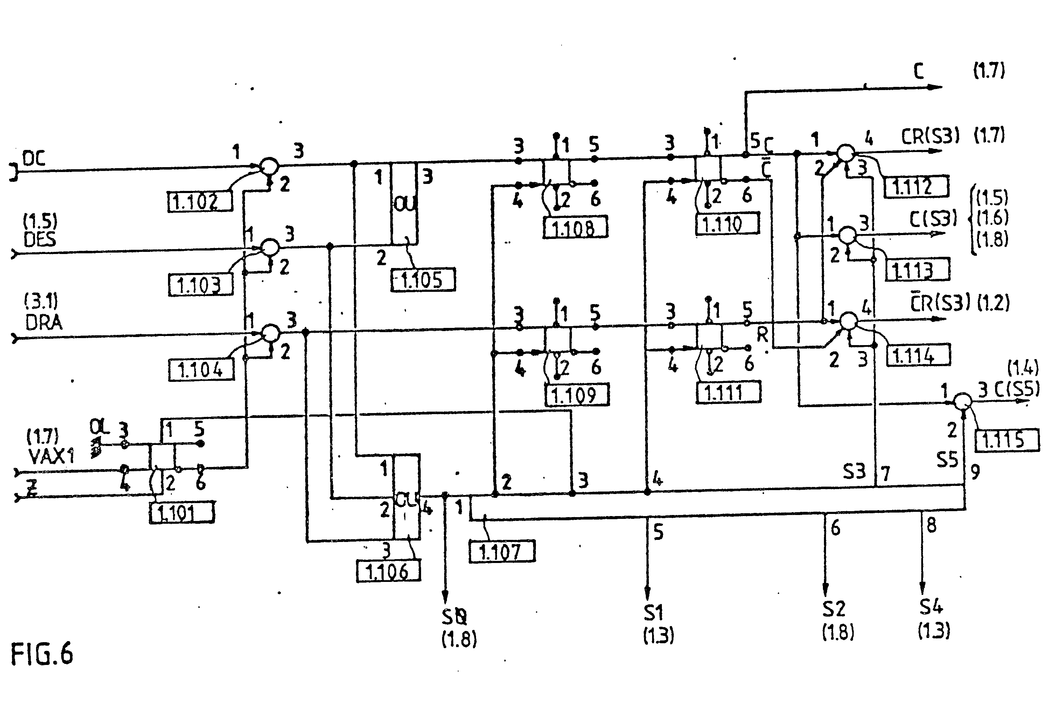

La figure 6 montre un mode de réalisation détaillée du Sélecteur-Lanceur de la figure 2. Le dispositif représenté à la figure 6 s'applique à un banc de mémoire sollicité par seulement deux demandes d'utilisation: l'une matérialisée par les signaux DC ou DES postule à l'exécution dans le banc de mémoire d'un cycle utile (lecture ou écriture d'une information), l'autre concrétisée par le signal DRA demande l'exécution dans ce même banc de mémoire d'un cycle de rafraîchissement apparent.

Les signaux DC, DES et DRA sont appliqués respectivement sur l'entrée 1 des circuits ET notés 1.102, 1.103 et 1.104 de la figure 2. L'entrée 2 de chacun de ces circuits ET reçoit un signal de validation provenant de la sortie 6 du basculeur 1.101 lorsqu'une transition positive est appliquée sur l'entrée 4 de ce basculeur. Cette transition positive est le front avant d'une impulsion désignée sous le nom VAX1.

Les circuits ET 1.102 et 1.103 attaquent à partir de leur sortie 3 les entrées 1 et 2 du circuit logique OU 1.105. Celui-ci est relié par sa sortie 3 à l'entrée 3 du basculeur 1.108. Ce dernier est monté en cascade avec un second basculeur 1.110, c'est-à-dire en reliant sa sortie 5 sur l'entrée 3 de ce second basculeur.

En parallèle, la sortie 3 du circuit ET 1.104 attaque l'entrée 3 du basculeur 1.109, lui-même monté également en cascade avec le circuit 1.111.

En outre, les circuits ET de validation des demandes 1.102, 1.103 et 1.104 sont reliés par leur sortie 3 aux entrées respectives 1, 2 et 3 du circuit logique OU 1.106. Ce dernier délivre sur sa sortie 4 le signal SO. Il attaque aussi une ligne à retard 1.107. Cette dernière sychronise les basculeurs 1.108 et 1.109 sur leur entrée d'horloge 4 à partir de sa sortie calibrée 2; elle synchronise également les basculeurs 1.110 et 1.111 à partir de sa sortie calibrée 4. Elle remet à zéro la sortie 6 du basculeur 1.101 en appliquant l'impulsion issue de sa sortie 3 sur l'entrée 1 de ce basculeur. Elle fournit en outre, divers signaux retardés de manière calibrée S1, S2, S3, S4 et S5 sur ses sorties respectives 5, 6, 7, 8 et 9.

Si l'on désigne par C et C respectivement les sorties 5 et 6 du basculeur 1.110 et R la sortie 5 du basculeur 1.111, il apparaît sur la figure 6 que les circuits logiques ET 1.112, 1.113 et 1.114 réalisent dans le même ordre les fonctions logiques ET suivantes de ces différents signaux: CR (S3) sur la sortie 4 du circuit ET 1.112 recevant C en entrée 1, R en entrée 2 et S3 en entrée 3, C (S3) sur la sortie 3 du circuit ET 1.113 recevant C en entrée 1 et S3 en entrée 2 et enfin CR (S3) sur la sortie 4 du circuit ET 1.114 recevant R en entrée 1, C en entrée 2 et S3 en entrée 3. Le circuit logique ET 1.115 délivre la fonction C (S5) sur sa sortie 3 à partir des signaux C sur son entrée 1 et S5 sur son entrée 2.

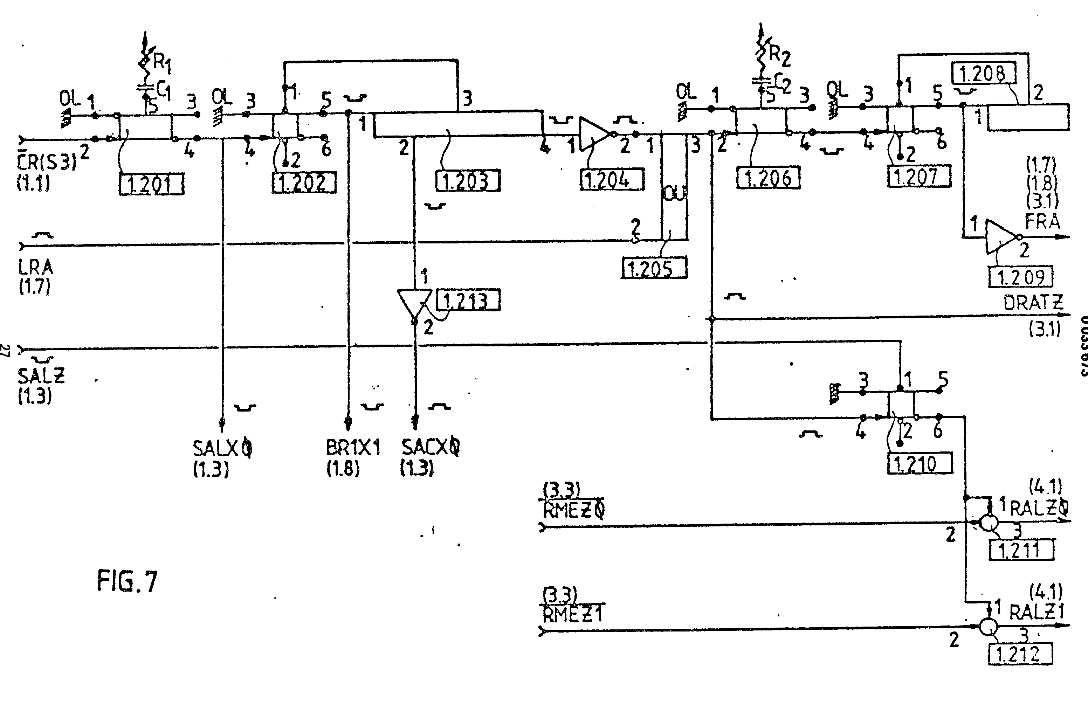

La figure 7 est une représentation détaillée du générateur de rafraîchissement apparent de la figure 2.

Le Générateur de Rafraîchissement Apparent est excité par le signal CR (S3) issu du Sélecteur-Lanceur ou par le signal LRA issu du Terminateur de Cycle. Il déclenche le lancement d'un cycle de rafraîchissement apparent dont la commande dans le Sous-Ensemble de mémorisation est assurée par la transmission, avec la synchronisation convenable, des signaux RALZ0 et RALZ1.

Le signal CR (S3) provenant du Sélecteur-Lanceur attaque l'entrée d'horloge 2 du monostable côté 1.201 sur la figure 7. L'entrée de donnée 1 de ce monostable est validée au travail par un signal au zéro logique. Sur l'entrée 5 de ce même monostable est câblé le réseau résistance-capacité $R_1$ $C_1$ qui détermine la constante de temps fixant la durée du signal de sortie. La résistance $R_1$ étant ajustable, il sera possible de régler cette constante de temps à la valeur convenable. La sortie 4 délivre la valeur complémentée du signal de sortie qui se présente donc sous forme d'une impulsion négative à durée réglable. Cette dernière est transmise sous le nom SALX0 à l'Excitateur de mémoire. Elle est aussi dirigée sur l'entrée d'horloge 4 du basculeur 1.202 qui reçoit par ailleurs la valeur logique zéro sur son entrée de donnée 3. Le front arrière de l'impulsion négative est une transition montante qui, par conséquent, active le basculeur 1.202. Celui-ci délivrera alors un signal négatif sur sa sortie 5. Ce signal négatif est transmis à l'entrée 1 de la ligne à retard 1.203 qui, au bout d'un retard calibré, réinjecte ce signal négatif à partir de sa sortie 3 sur l'entrée continue 1 du basculeur 1.202. Ce dernier porte alors sa sortie 5 à la valeur logique un, ce qui interrompt le signal négatif émis sur sa sortie 5. La sortie 2 de la ligne à retard 1.203 délivre une impulsion au retard calibré qui, reçue sur l'entrée 1 de l'inverseur 1.213 est complémentée à la sortie 2 de cet inverseur pour être dirigée sur l'Excitateur de Mémoire sous le nom SACX0. L'impulsion négative constituant le signal de la sortie 5 du basculeur 1.202 est transmise sous le nom BR1X1 au Générateur de Commande d'assignation (1.8).

La sortie 4 de la ligne à retard 1.203 est connectée à l'entrée 1 de l'inverseur 1.204; ceci a pour effet de faire apparaître sur la sortie 2 de cet inverseur une impulsion position convenablement retardée qui est dirigée sur l'entrée 1 de la porte logique OU 1.205. Ce circuit OU reçoit aussi sur son entrée 2 le signal LRA issu du Terminateur de Cycle. Il délivre sur sa sortie 3 une impulsion appelée DRATZ qui est transmise à l'Excitateur de rafraîchissement.

Cette même impulsion, dirigée sur l'entrée d'horloge 2 du monostable 1.206, lui-même commandé au travail sur son entrée de donnée 1, provoque l'apparition d'une impulsion négative en sortie 4 de ce monostable. La durée de cette impulsion est calibrée par le réseau résistance-capacité $R_2 C_2$, réglable par sa résistance $R_2$, câblé sur l'entré 5 du monostable 1.206. La sortie 4 du monostable 1.206 est reliée à l'entrée d'horloge 4 du basculeur 1.207 qui reçoit par ailleurs la valeur logique zéro sur son entrée de donnée 3. Le front arrière de l'impulsion négative issue de la sortie 4 du monostable 1.206 va donc provoquer l'apparition d'un signal négatif en sortie 5 du basculeur 1.207. Le signal est transmis à l'entrée 1 de la ligne à retard 1.208. Il se retrouvera un peu plus tard à la sortie 2 de cette ligne, puis à l'entrée continue 1 du basculeur 1.207. La sortie 5 est alors mise à un, ce qui termine l'impulsion négative émise. Cette impulsion est aussi transmise à l'entrée 1 de l'inverseur 1.209 qui l'inverse et l'envoie ainsi, à partir de sa sortie 2, sous le nom FRA au Terminateur de Cycle, au Générateur de Commande d'Assignation et à l'excitateur de Rafraîchissement.

Le basculeur 1.210 reçoit sur son entrée d'horloge 4 l'impulsion DRATZ issue de la sortie 3 du circuit OU 1.205; son entrée de donnée 3 est mise à la valeur logique zéro et il est initialisé à la valeur logique zéro sur sa sortie 6 au moyen du signal SALZ accédant à son entrée continue 1. Ce signal SALZ provient de l'Excitateur de Mémoire. L'impulsion DRATZ transfère donc la valeur logique zéro sur la sortie 5 du basculeur 1.210, c'est-à-dire la valeur logique un sur la sortie 6, jusqu'au moment de la remise à zéro par le signal SALZ. Pendant sa mise à un, la sortie 6 valide les entrées 1 des circuits logiques ET 1.211 et 1.212 qui émettent alors une valeur logique vraie sur leur sortie 3 sous les noms de signaux RALZ0 et RALZ1 si les conditions respectives d'entrée RMEZ0 et RMEZ1 reçues sur leur entrée 2 sont elles-mêmes au travail. Les conditions RMEZ0 et RMEZ1 proviennent de l'Enregistreur de Rafraîchissement Masqué et les signaux de sortie

RALZ0 et RALZ1 sont destinées au Distributeur de Commandes pour les zones de Mémoire.

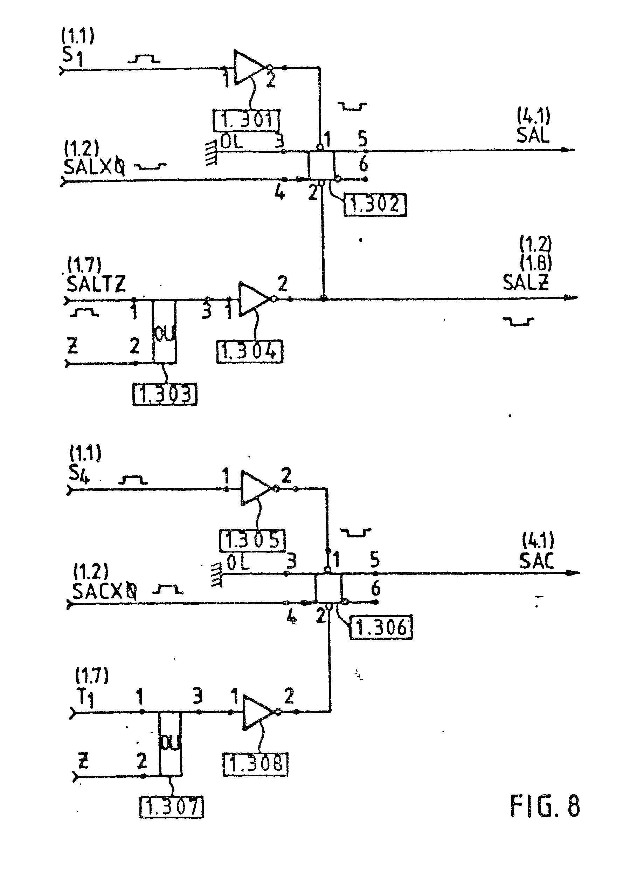

L'Excitateur de Mémoire est détaillé sur la figure 8. Il est excité au moyen des signaux de synchronisation $S_1$ et $S_4$ issus du Sélecteur-Lanceur. Il actionne le Sous-Ensemble de Mémorisation au moyen des signaux de commande de Sélection d'Adresse Ligne, SAL, et de Sélection d'Adresse Colonne, SAC.

Le signal $S_1$ issu du Sélecteur-Lanceur est une impulsion positive. Il est dirigé sur l'entrée 1 de l'inverseur 1.301 qui délivre donc une impulsion négative sur sa sortie 2. Cette impulsion négative attaque l'entrée continue 1 du basculeur 1.302 qui prend par suite la valeur logique vraie sur sa sortie 5, déclenchant ainsi l'envoi du signal SAL vers le Distributeur de Commandes pour les Zones de Mémoire. L'entrée de donnée 3 du basculeur 1.302 est portée de manière permanente à la valeur logique »0«; le front arrière du signal négatif SALX0 issu du Générateur de Rafraîchissement Apparent provoque donc une remise à zéro du signal SAL sur la sortie 5 de ce basculeur. Une autre remise à zéro est obtenue par la mise au travail sur l'entrée continue 2 du signal SALZ. Ce signal provient de la sortie 2 de l'inverseur 1.304 dont l'entrée 1 est reliée à la sortie 3 du circuit logique OU 1303. Ce dernier reçoit le signal général d'initialisation Z sur son entrée 2, et, sur son entrée 1, le signal SALTZ provenant du Terminateur de Cycle. Le signal SALZ issu de la sortie 2 de l'inverseur 1.304 est également dirigé sur le Générateur de Rafraîchissement Apparent et sur le Générateur de Commande d'Assignation.

De la même manière, le signal $S_4$ issu avec un retard calibré du Sélecteur-Lanceur attaque l'entrée 1 de l'inverseur 1.305. Il réapparaît ainsi sous forme complémentée à la sortie 2 de cet inverseur pour commander l'entrée 1 du basculeur 1.306. Ce dernier porte alors à la valeur logique »un« sa sortie 5 qui délivre le signal SAC à destination du Distributeur de Commandes pour les Zones de Mémoire. L'entrée de donnée 3 du basculeur 1.306 étant portée en permanence au zéro logique, le signal SACX0 émis par le Générateur de Rafraîchissement Apparent provoque la remise à zéro du signal SAC de la sortie 5. Une autre remise à zéro est obtenue par l'action de la sortie 2 de l'inverseur 1.308 sur l'entrée continue 2 du basculeur 1.306. L'entrée 1 de l'inverseur 1.308 est connectée à la sortie 3 du circuit logique OU 1.307 qui reçoit respectivement sur ses entrées 2 et 1, le signal d'initialisation Z et le signal de synchronisation $T_1$ issu de Terminateur de Cycle.

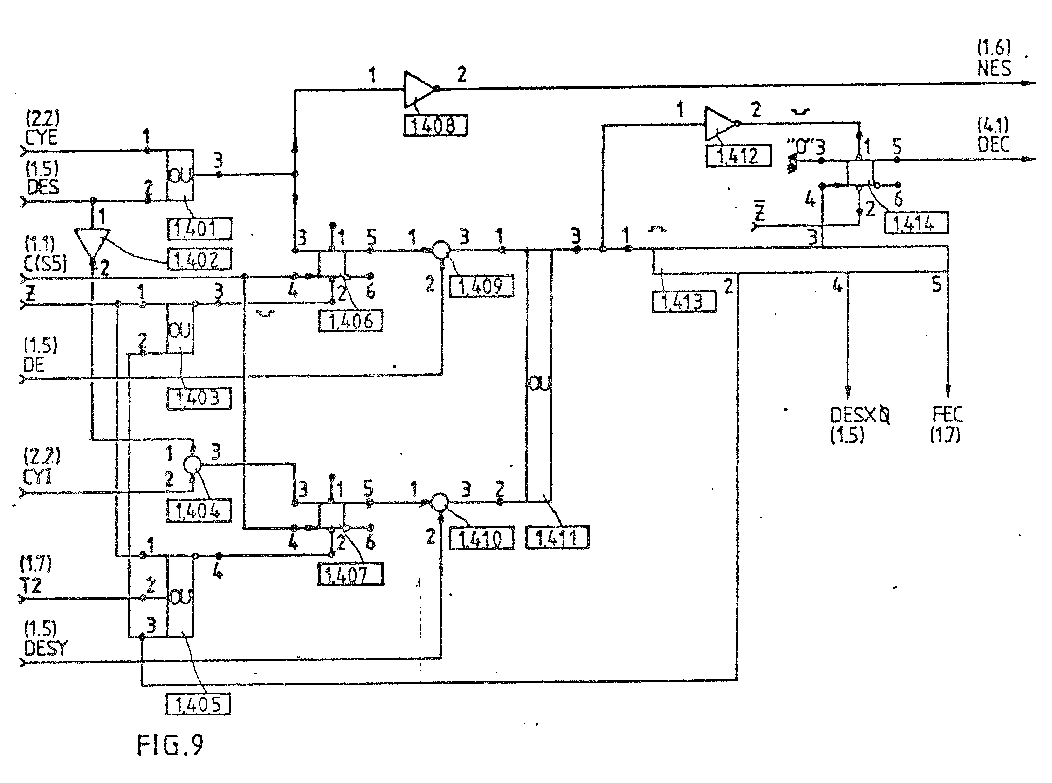

Le Scripteur est détaillé sur la figure 9. Il déclenche l'action d'écriture au moyen du signal DEC dans le Sous-Ensemble de Mémorisation lorsque cette action est demandée sur l'interface par le signal DE et que les conditions technologiques d'écriture sont réunies. Ce dernier contrôle s'effectue à l'aide du Générateur de Régulation d'Ecriture qui communique avec le Scripteur par l'ensemble des signaux DES, DESY et DESX0.

Le circuit logique OU 1.411 est connecté sur son entrée 1 à la sortie 3 de la porte logique ET 1.409 et, sur son entrée 2, à la sortie 3 de la porte logique ET 1.410. Ces deux voies correspondent à deux modes différents de déclenchement d'écriture. La première voie de déclenchement s'effectue à travers la porte logique ET 1.409 qui reçoit sur son entrée 2 le signal DE issu de l'interface à travers le Générateur de Régulation d'Ecriture et sur son entrée 1, le signal affiché par la sortie 5 du basculeur 1.406. Ce basculeur est mis au' travail, c'est-à-dire à la valeur logique »un« sur sa sortie 5, si son entrée de donnée 3 était à »un« au moment de la transition montante du signal C(S5) sur son entrée d'horloge 4. Ce signal provient du Sélecteur-Lanceur. L'entrée de donnée 3 du basculeur 1.406 est connectée à la sortie 3 du circuit logique OU 1.401 qui transmet ainsi les conditions de mise au travail du basculeur 1.406 reçues sur ses entrées 1 et 2, à savoir, respectivement, l'état de travial du signal CYE provenant du Registre de Fonction ou l'état de travail du signal DES émis par le Générateur de Régulation d'Ecriture. La sortie 3 du circuit logique OU 1.401 est également connectée à l'entrée 1 de l'inverseur 1.408 qui par sa sortie 2 communique le signal NES au Lecteur. Le basculeur 1.406 est remis au repos par l'intermédiaire de l'outil logique OU inverseur 1.403 dont la sortie 3 est câblée sur l'entrée continue 2 de ce basculeur. Les entrées 1 et 2 de cet outil logique OU inverseur 1.403 reçoivent respectivement, le signal général d'initialisation Z et l'impulsion issue de la sortie 2 de la ligne à retard 1.413 du Scripteur.

La seconde voie de déclenchement s'effectue à travers le circuit logique ET 1.410 qui reçoit, sur son entrée 2, le signal de commande DESY engendré par le Générateur de Régulation d'Ecriture et, sur son entrée 1, le signal issu de la sortie 5 du basculeur 1.407. Ce basculeur produit un signal à la valeur logique »un« sur sa sortie 5 lorsque son entrée de donnée 3 était à »un« pendant la mise à un de son entrée d'horloge 4. Cette dernière est, comme pour le basculeur 1.406 commandée par le signal C(S5) issu du Sélecteur-Lanceur. L'entrée de donnée 3 du basculeur 1.407 est alimentée par la sortie 3 du circuit logique ET 1.404. Ce circuit ET reçoit la valeur complémentée du signal DES sur son entrée 1 et le signal CYI issu du Registre de Fonction (2.2.) sur son entrée 2. La sortie 2 de l'inverseur 1.402 qui admet le signal DES sur son entrée 1 est en effet connectée à l'entrée 1 du circuit ET 1.404. Le basculeur 1.407 est remis à zéro sur sa sortie 5 par l'action sur son entrée 2 du signal engendré par la sortie 4 du circuit OU-inverseur 1.405. Le circuit OU-inverseur 1.405 est lui-même alimenté par le signal général d'initialisation Z sur son entrée 1, par le signal de synchronisation T2 issu du Terminateur de Cycle sur son entrée 2, et enfin, par l'impulsion issue de la sortie 2 de la ligne à retard 1.413 du Scripteur sur son entrée 3.

Le circuit logique OU 1.411 délivre dans les deux cas de déclenchement une impulsion sur sa sortie 3 à destination, d'une part, de l'entrée 1 de la ligne à retard 1.413 et, d'autre part, de l'entrée 1 de l'inverseur 1.412. La sortie 2 de l'inverseur 1.412 émet alors une impulsion négative vers l'entrée continue 1 du basculeur 1.414 dont la sortie 5 est, par suite, mise à la valeur logique vraie. Le signal de Déclenchement d'Ecriture DEC ainsi engendré est lancé vers le Distributeur de Commande pour les Zones de Mémoire. Le basculeur 1.414 est remis à zéro par l'action sur son entrée d'horloge 4 de l'impulsion issue de la sortie 3 de la ligne à retard 1.413, son entrée de donnée 3 étant en permanence cablée à la valeur logique »zéro«. La valeur complémentée du signal général d'initialisation Z met aussi à zéro la sortie 5 du basculeur 1.414 par action sur l'entrée continue 2 de ce basculeur. La ligne à retard 1.413 délivre en outre les signaux de synchronisation DESX0 et FEC à destination, respectivement, du Régulateur d'Ecriture et du Terminateur de Cycle.

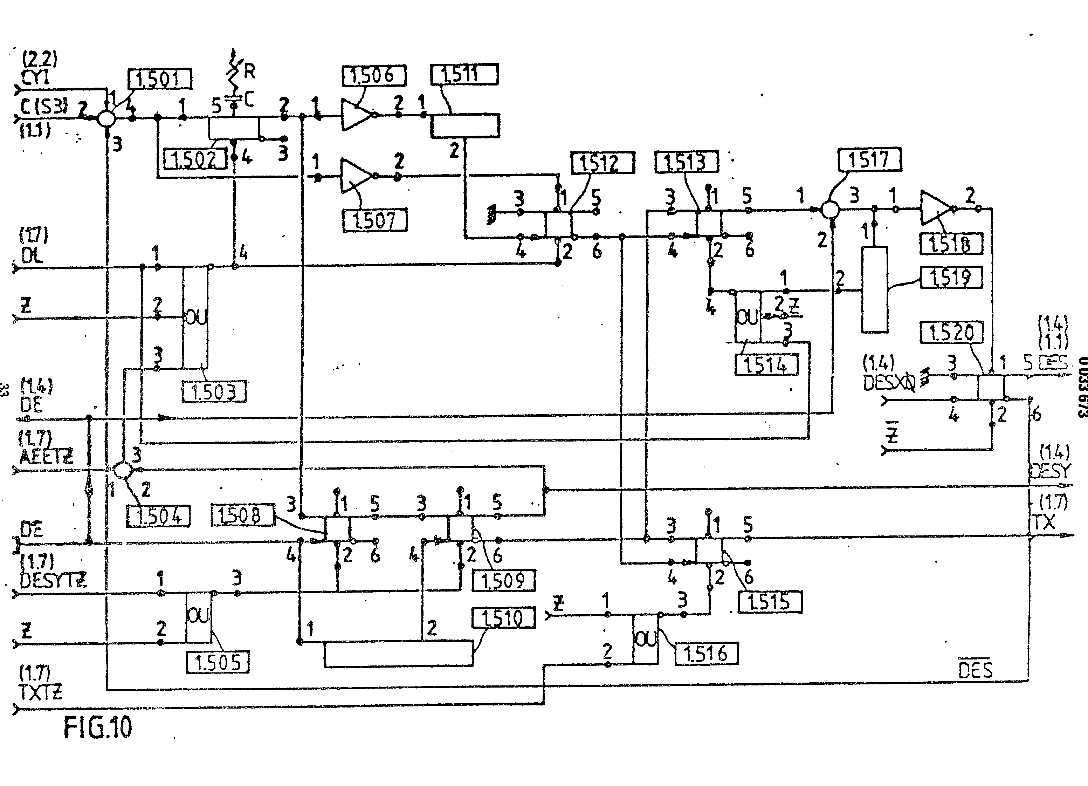

Le Générateur de Régulation d'Ecriture, ou plus simplement le Régulateur d'Ecriture, est présenté de manière détaillée sur la figure 10. Il gère les Demandes d'Ecriture présentées sous forme du signal d'interface DE par les organes utilisateurs du banc de mémoire. Cette gestion des Demandes d'Ecriture est assurée en fonction de la disponibilité technologique du sous-ensemble de Mémorisation qui n'admet de déclenchement d'écriture que sous certaines conditions chronologiques très précises. En gérant ainsi les Demandes d'Ecriture, le Régulateur d'Ecriture contrôle le fonctionnement du Scripteur avec lequel il communique au moyen des signaux DE, DES et DESY. L'animation du Régulateur d'Ecriture dépend de tous les autres sous-organes qui l'environnent.

C'est ainsi que le Sélecteur-Lanceur fournit le signal C(S3) sur l'entrée 2 du circuit logique ET 1.501. Ce signal C(S3) est ainsi conditionné au moyen de cette porte logique ET 1.501 par le signal CYI émis par le Registre de Fonction sur l'entrée 1 et par le signal DES provenant sur l'entrée 3 de la sortie 6 du basculeur 1.520. La sortie 4 du circuit logique ET 1.501 est reliée d'une part à l'entrée 1 du monostable 1.502 et d'autre part à l'entrée 1 de l'inverseur 1.507. Après filtrage, le signal C(S3) déclenche ainsi le monostable 1.502 et initialise à zéro la sortie 6 du basculeur 1.512 qui reçoit en effet, sur son entrée continue 1 le signal émis par la sortie 2 de l'inverseur 1.507. La durée du signal positif apparaissant sur la sortie 2 du monostable 1.502 est calibrée à l'aide du réseau Résistance-Capacité RC connecté sur l'entrée 5 de ce monostable.

La Résistance R réalisée au moyen d'un potentiomètre est ajustable et permet donc de régler avec précision la durée en question. Ainsi calibré, le signal de sortie du monostable est aiguillé, d'une part, sur l'entrée 1 de l'inverseur 1.506 et d'autre part, sur l'entrée 3 du basculeur 1.508. La sortie 2 de l'inverseur 1.506 alimente ainsi l'entrée 1 de la ligne à retard 1.511 avec le signal complémenté du signal de sortie du monostable 1.502. Ce signal complémenté se retrouve au bout d'un temps de retard calibré sur la sortie 2 de la ligne à retard 1.511 pour aller exciter l'entrée d'horloge 4 du basculeur 1.512. L'entrée de donnée 3 de ce basculeur 1.512 étant câblée en permanence au »zéro« logique, cette valeur est alors transférée à l'apparition du front arrière du signal complémenté d'excitation de l'entrée d'horloge 4 et la sortie 6 prend par suite la valeur logique »un«. Le basculeur 1.512 et le monostable 1.502 sont remis à zéro par la mise au travail du circuit logique OU-inverseur 1.503 dont la sortie 4 est connectée d'une part, à l'entrée continue 2 du basculeur 1.512 et d'autre part, à l'entrée de remise à zéro 4 du monostable 1.502. Le circuit logique OU-inverseur 1.503 est lui-même actionné sur son entrée 1, par le signal DL issu du Terminateur de Cycle (1.7), sur son entrée 2, par le signal général d'initialisation Z et sur son entrée 3, par la sortie 3 du circuit logique ET 1.504 qui lui-même conditionne le signal AEETZ présenté à son entrée 1 et issu du Terminateur de Cycle par le signal injecté sur son entrée 2 par la sortie 5 du basculeur 1.509.

Le basculeur 1.508 reçoit, on l'a vu, sur son entrée de donnée 3 le signal direct engendré par le monostable 1.502. Il est par suite déclenché par le signal d'interface DE câblé sur son entrée d'horloge 4 si la transition montante de ce signal DE a lieu pendant la durée du signal provenant du monostable 1.502. Dans ce cas, la sortie 5 du basculeur 1.508 est mise à la valeur »un« logique et communique ce niveau logique à l'entrée de donnée 3 du basculeur 1.509. Ce niveau vrai sera lui-même retransféré sur la sortie 5 du basculeur 1.509 par action du signal issu de la sortie 2 de la ligne à retard 1.510 sur l'entrée d'horloge 4 de ce basculeur. La ligne à retard 1.510 reçoit quant à elle sur son entrée 1, le signal d'interface DE qui assure ainsi lui-même, au moyen de ce mécanisme, son autosynchronisation par rapport au signal de sortie du monostable 1.502. La sortie 6 du basculeur 1.509 prend par définition la valeur complémentée de celle de la sortie 5 de ce basculeur qui émet le signal DESY vers le Scripteur. Les basculeurs 1.508 et 1.509 sont réinitialisés à la valeur logique »zéro« sur leur sortie 5 par action sur leur entrée continue 2 du signal issu de la sortie 3 du circuit OU-inverseur 1.505. Ce dernier reçoit le signal DESYTZ issu du Terminateur de Cycle sur son entrée 1 et le signal général d'initialisation Z sur son entrée 2. Par ailleurs, la sortie 6 du basculeur 1.509 conditionne l'entrée de donnée 3 du basculeur 1.515 et la sortie 6 du basculeur 1.512 est connectée à l'entrée d'horloge 4 du basculeur 1.515. Par conséquent, si le signal issu de la sortie 6 du basculeur 1.509 est à la valeur logique vraie au moment de l'arrivée du signal délivré par la sortie 6 du basculeur 1.512 sur l'entrée d'horloge 4 du basculeur 1.515, ce basculeur 1.515 produit le signal positif appelé TX sur sa sortie 5. Ce signal TX est destiné au Terminateur de Cycle (1.7). Il est émis jusqu'à remise à zéro de la sortie 5 du basculeur 1.515 par action de la sortie 3 de l'outil logique OU-inverseur 1.516 sur l'entrée continue 2 du basculeur 1.515.

L'outil logique 1.516 est lui-même commandé par le signal général d'initialisation Z sur son entrée 1 et par le signal TXTZ provenant du Terminateur de Cycles sur son entrée 2.

La sortie 6 du basculeur 1.509 conditionne aussi l'entrée de donnée 3 du basculeur 1.513. Ce dernier est déclenché si le signal arrivant sur son entrée de donnée 3 est à la valeur logique »un« lorsque la sortie 6 du basculeur 1.512 délivre un signal positif sur l'entrée d'horloge 4 de ce basculeur 1.513 à laquelle elle est connectée. La sortie 5 du basculeur 1.513 prend alors la valeur logique »un« et la communique à l'entrée 1 du circuit logique ET 1.517. Lorsque le signal d'interface DE apparaîtra sur l'entrée 2 de ce circuit logique ET 1.517, la sortie 3 prendra aussi la valeur logique »un«. Un signal de travail à »un« logique sera alors transmis d'une part à l'entrée 1 de la ligne à retard 1.519 et d'autre part, à l'entrée 1 de l'inverseur 1.518. Au niveau de la ligne à retard 1.519, ce signal de travail a pour effet de remettre au repos le basculeur 1.513, c'est-à-dire à »zéro«, la sortie 5 de ce basculeur, en se propageant dans la polarité convenable de la sortie 2 de la ligne à retard 1.519 sur l'entrée 1 de l'outil OU-inverseur 1.514 puis, de la sortie 4 de cet outil sur l'entrée continue 2 du basculeur 1.513. La réinitialisation de ce basculeur 1.513 est également obtenue par application de signaux sur les entrées 2 ou 3 du circuit OU-inverseur 1.514. Ces signaux sont soit le signal général d'initialisation Z sur l'entrée 2 du circuit 1.514, soit le signal DL provenant de l'interface à travers le Terminateur de Cycle 1.7 et câblé sur l'entrée 3 du circuit 1.514.

La sortie 2 de l'inverseur 1.518 est quant à elle connectée à l'entrée continue 1 du basculeur 1.520. Le signal de travail précédent provoque donc aussi la mise à la valeur logique »un« du signal DES sur la sortie 5 du basculeur 1.520. Ce signal DES est utilisé dans le Sélecteur-Lanceur (1.1) et le Scripteur (1.4). Le signal DES est remis à zéro par action du signal DESX0 issu du scripteur (1.4) sur l'entrée d'horloge 4 du basculeur 1.520, un »zéro« logique permanent étant câblé sur l'entrée de donnée 3 de ce basculeur. Le signal général d'initialisation complémenté Z procure aussi une remise à zéro initiale du signal DES par action sur l'entrée continue 2 du basculeur 1.520.

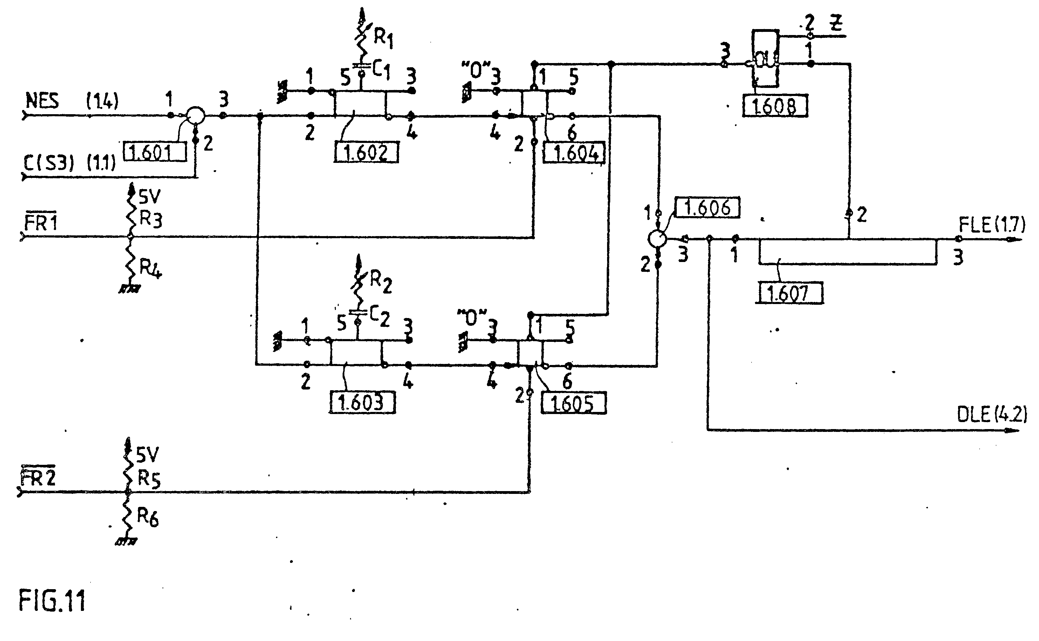

Le Lecteur ou Excitateur de Lecture est représenté en détail sur la figure 11. Il est mis en oeuvre sur incitation du Sélecteur-Lanceur au moyen du signal C(S3). Il déclenche l'action de lecture dans le sous-ensemble de Mémorisation à l'aide du signal DLE.

Le signal C(S3) provenant du Sélecteur-Lanceur active l'entrée 2 du circuit logique ET 1.601 conditionné par ailleurs sur son entrée 1 par le signal NES élaboré dans le Scripteur. La sortie 3 de la porte logique ET 1.601 est connectée aux entrées 2 des monostables 1.602 et 1.603. Les entrées 1 de ces monostables sont validées en permanence au moyen d'un niveau constant au »zéro« logique (inversé de manière interne). Le signal de la sortie 3 de la porte ET 1.601 provoque donc le déclenchement de ces monostables qui délivrent alors une impulsion négative sur leur sortie 4. Les durées de ces impulsions issues des monostables 1.602 et 1.603 sont calibrées respectivement par les réseaux de résistances-capacités ($R_1$, $C_1$) et ($R_2$, $C_2$) cablés sur les entrées 5 de ces monostables. Les résistances $R_1$ et $R_2$ sont ajustables, ce qui permet de régler les durées des impulsions avec précision. Les sorties 4 des monostables 1.602 et 1.603 sont respectivement connectées aux entrées d'horloge 4 des basculeurs 1.604 et 1.605. L'entrée de donnée 3 de ces basculeurs étant fixée au »zéro« logique, le front arrière des impulsions issues des monostables entraîne donc la mise à »zéro« de la sortie 5 et la mise à »un« de la sortie 6 de ces basculeurs.

L'initialisation des basculeurs 1.604 et 1.605 au »zéro« logique sur leur sortie 6, est assurée par le signal engendré par la sortie 3 de l'outil OU-inverseur 1.608 branchée sur l'entrée continue 1 de ces basculeurs. Il est par ailleurs possible de forcer la sortie 6 des basculeurs 1.604 et 1.605 en agissant sur l'entrée continue 2 de ces basculeurs. A titre indicatif, ceci est réalisé dans la technologie TTL en portant au potentiel zéro les équipotentielles notées respectivement FR1 et FR2 accessibles de l'extérieur. Les réseaux de résistances ($R_3$, $R_4$) d'une part sur l'entrée continue 2 du basculeur 1.604 et ($R_5$, $R_6$) d'autre part sur l'entrée continue 2 du basculeur 1.605 garantissent le niveau de repos (»un« logique) pendant le fonctionnement.

Les sorties 6 des basculeurs 1.604 et 1.605 valident respectivement les entrées 1 et 2 du circuit ligique ET 1.606. La sortie 3 de cet outil logique ET est alors mise au »un« logique lorsque les deux entrées 1 et 2 sont au travail. L'entrée 1 de la ligne à retard 1.607 reliée à la sortie 3 du circuit 1.606 est alors excitée et le signal DLE est alors délivré à destination du sous-ensemble des Zones de Mémoire. La sortie 2 de la ligne à retard 1.607 retransmet ensuite avec un retard calibré, à l'entrée 1 de l'outil 1.608 le signal injecté sur l'entrée 1 de cette ligne. Cela a pour effet de remettre à zéro le signal de la sortie 6 des basculeurs 1.604 et 1.605 et donc de calibrer la durée de ce signal. Le signal général d'initialisation Z sur l'entrée 2 de l'outil OU-inverseur 1.608 assure la mise à zéro initiale de la sortie 6 des basculeurs 1.604 et 1.605. La ligne à retard 1.607 engendre en outre sur sa sortie 3 le signal FLE à l'usage du Terminateur de Cycle.

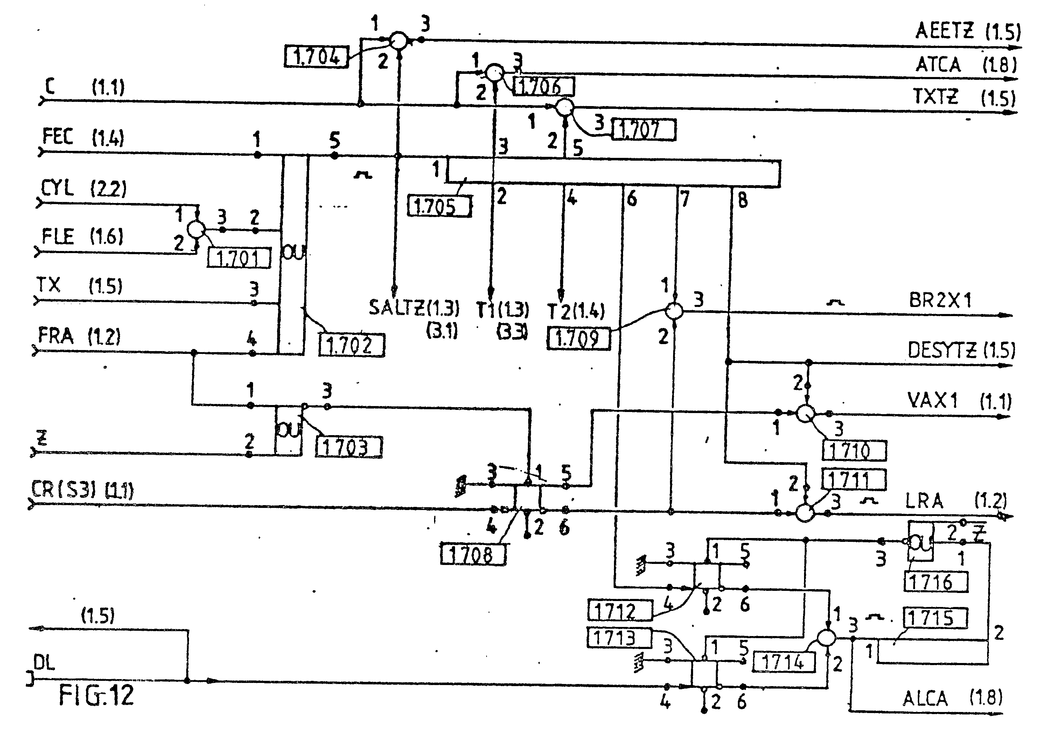

Le Terminateur de Cycle (ou Opérateur de Réarmement) fait l'objet détaillé de la figure 12. La fonction essentielle du Terminateur de Cycle est de préparer la relance d'un nouveau cycle de mémoire en réinitialisant le Sélecteur-Lanceur au moyen du signal VAX1. Le Terminateur de Cycle est mis en oeuvre à l'aide des signaux d'indication de fins d'opérations élémentaires provenant de différents sous-organes, comme les signaux, FEC issu du Scripteur, FLE du Lecteur ou FRA du Générateur de Rafraîchissement Apparent.

C'est ainsi que les entrées 1, 2, 3 et 4 de l'outil OU logique 1.702 reçoivent respectivement le signal de fin d'écriture FEC issu du Scripteur, le signal de la sortie 3 du circuit ET logique 1.701 actionné en fin de lecture, le signal TX provenant du Régulateur d'Ecriture et le signal de Fin de Rafraîchissement Apparent FRA délivré par le Générateur de Rafraîchissement. Le circuit ET logique 1.701 est commandé par le signal de Fin de Lecture FLE issu du Lecteur alimentant son entrée 2; il est conditionné sur son entrée 1 par le signal d'indication de Cycle de Lecture CYL. Ce signal CYL provient du Registre de Fonction. La sortie 5 de l'outil OU logique 1.702 excite l'entrée 1 de la ligne à retard 1.705, commande l'entrée 2 de l'outil ET logique 1.704 et fournit le signal SALTZ aux sous-organes (1.3) et (3.1) c'est-à-dire respectivement à l'Excitateur de Mémoire et à l'Excitateur de Rafraîchissement. La ligne à retard 1.705 délivre directement à partir de ses sorties 2 et 4 les impulsions de synchronisation T1 et T2 convenablement retardées à destination respectivement d'une part de l'Excitateur de Mémoire et de l'Enregistreur de Rafraîchissement Masqué et d'autre part du Scripteur. La sortie 3 de la ligne à retard 1.705 commande l'entrée 2 de l'outil ET 1.706, la sortie 5, l'entrée 2 de l'outil ET 1.707, la sortie 6, l'entrée d'horloge 4 du basculeur 1.712, la sortie 7, l'entrée 1 de l'outil ET 1.709 et enfin la sortie 8, l'entrée 2 des circuits logiques ET 1.710 et 1.711. En outre, le signal engendré par la sortie 8 de la ligne à retard 1.705 prend le nom DESYTZ pour alimenter le Régulateur d'Ecriture. Les circuits logiques ET 1.704, 1.706 et 1.707 sont tous conditionnés sur leur entrée 1 par le signal C issu du Sélecteur-Lanceur. Ils produisent respectivement sur leur sortie 3 les signaux AEETZ au profit du Régulateur d'Ecriture, ATCA à l'usage du Générateur de Commande d'Assignation et TXTZ à destination également du Régulateur d'Ecriture.

Le signal de Fin de Rafraîchissement Apparent FRA attaque par ailleurs l'entrée 1 de l'outil OU logique 1.703 dont la sortie 3 est reliée à l'entrée continue 1 du basculeur 1.708. Le signal général d'initialisation Z alimente l'entrée 2 de l'outil OU 1.703. Ces deux signaux Z ou FRA ont donc pour effet d'initialiser ou de réinitialiser le basculeur 1.708 à la valeur logique »un« sur sa sortie 5 et »zéro« sur sa sortie 6. Le basculeur 1.708 est mis au travail à la valeur logique »un« sur sa sortie 6 et »zéro« sur sa sortie 5 par action sur son entrée d'horloge 4 du signal CR(S3) issu du Sélecteur-Lanceur, son entrée de donnée étant par ailleurs fixée à la valeur logique »zéro«. La sortie 5 du basculeur 1.708 conditionne l'entrée 1 du circuit logique ET 1.710 qui délivrera sur sa sortie 3 le signal VAX1 au profit du Sélecteur-Lanceur. La sortie 6 du basculeur 1.708 conditionne quant à elle l'entrée 1 du circuit ET 1.711 et l'entrée 2 du circuit ET 1.709. Le circuit logique ET 1.711 produira sur sa sortie 3 le signal LRA à destination du Générateur de Rafraîchissement Apparent. Le circuit logique ET 1.709 engendrera pour sa part sur sa sortie 3 le signal BR2X1 fourni au Générateur de Commande d'Assignation.

A la réception sur son entrée d'horloge 4 du signal de synchronisation issu de la sortie 6 de la ligne à retard 1.705, le basculeur 1.712 présente un signal de sortie à la valeur logique »un« sur sa sortie complémentée 6, étant donné que son entrée de données est fixée à la valeur logique »zéro«. La sortie 6 du basculeur 1.712 est reliée à l'entrée 1 ainsi validée du circuit logique ET 1.714. Par ailleurs, le signal d'interface DL qui est réaiguillé vers le Régulateur d'Ecriture met au travail à la valeur logique »un« sur sa sortie complémentée 6 le basculeur 1.713 en actionnant l'entrée d'horloge 4 de ce basculeur, l'entrée de donnée de ce même dispositif étant portée par câblage à la valeur logique constante »zéro«. La sortie 6 de ce basculeur 1.713 est connectée à l'entrée 2 du circuit logique ET 1.714 qui se trouve ainsi complètement validé et délivre alors sur sa sortie 3 le signal ALCA à destination du Générateur de Commande d'Assignation. La sortie 3 du circuit logique ET 1.714 débite aussi sur l'entrée 1 de la ligne à retard 1.715, laquelle engendre au bout d'une retard calibré un signal positif sur sa sortie 2. Cette sortie 2 attaque l'entrée 1 de l'outil logique OU-inverseur 1.716 qui, par action de sa sortie 3 sur leur entrée continue 1, réinitialise les basculeurs 1.712 et 1.713. Le signal général d'initialisation Z sur l'entrée 2 de l'outil OU-inverseur 1.716 procure de même la mise à »zéro« initiale des sorties 6 de ces mêmes basculeurs 1.712 et 1.713.

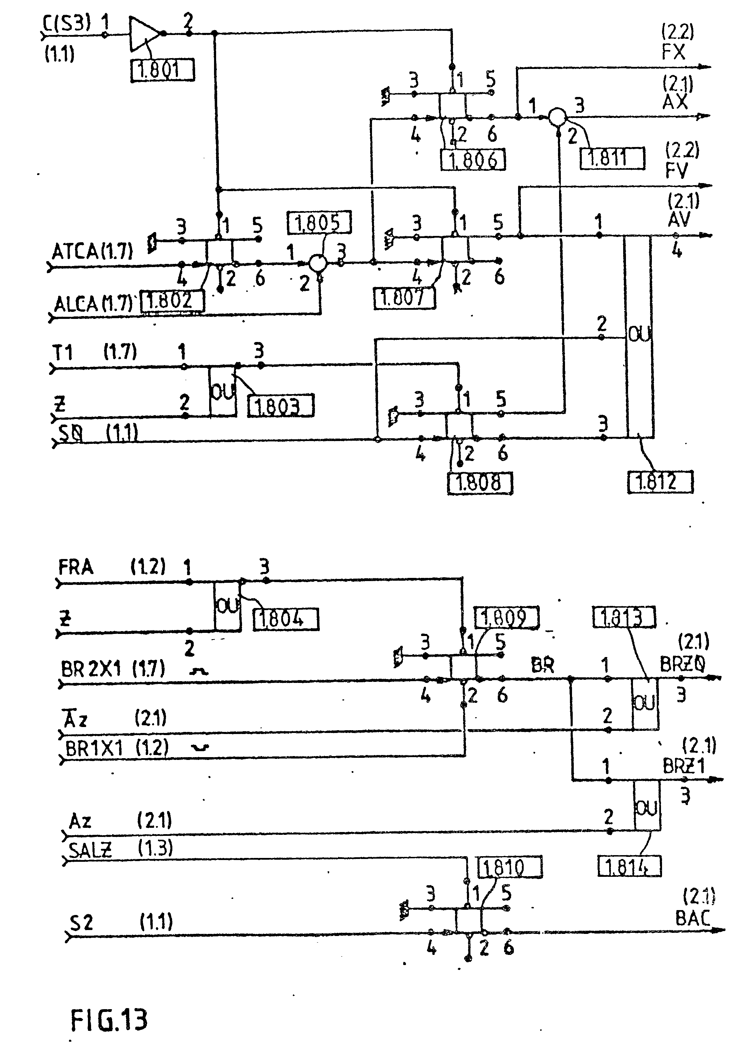

La figure 13 donne une représentation détaillée du Générateur de Commande d'Assignation. Ce sous-organe a pour fonction d'élaborer les commandes des registres d'assignation, c'est-à-dire les commandes d'une part, du Registre d'Adresse, et d'autre part, du Registre de Fonction. Ces commandes d'assignation doivent s'effectuer sous le contrôle général du Régulateur de Commande. C'est pourquoi le Générateur de Commande d'Assignation est l'un des sous-organes de cet ensemble auquel il est interconnecté de manière interne, plus particulièrement au Sélecteur-Lanceur, et au Terminateur.

Ainsi le Sécteur-Lanceur présente le signal C(S3) sur l'entrée 1 de l'inverseur 1.801. La sortie 2 de cet outil 1.801 injecte une impulsion négative sur l'entrée 1 des basculeurs 1.802, 1.806 et 1.807 pour leur communiquer ainsi l'état logique vrai sur leur sortie 5 et donc l'état logique faux sur leur sortie 6. Le Sélecteur-Lanceur (1.1) fournit également le signal S0 sur l'entrée d'horloge 4 du basculeur 1.808 et sur l'entrée 2 de l'outil logique OU 1.812, ce qui a pour effet de mettre le basculeur 1.808 dans l'état logique »zéro« sur sa sortie 5 et donc dans l'état logique »un« sur sa sortie complémentée 6. En effet, comme pour tous les basculeurs du Générateur de Commande d'Assignation, l'entrée de donnée 3 du basculeur 1.808 est mise à »zéro« de manière permanente par cablage d'une masse, ce qui provoque le transfert de la valeur logique »zéro« en sortie directe 5 sur toute transition positive d'horloge. Par ailleurs, l'application du signal S0 sur l'entrée 2 de l'outil OU 1.812 fait passer la sortie 4 de cet outil au niveau logique »un«, engendrant ainsi le signal AV au profit du Registre d'Adresse.

Pour sa part, le Terminateur de Cycle délivre les signaux ATCA, ALCA et T1. Le premier signal ATCA dirigé sur l'entrée d'horloge 4 du basculeur 1.802 aura pour effet de mettre ce dernier dans l'état logique »un« sur sa sortie complémentée 6, par transfert de zéro sur sa sortie directe 5 comme on l'a vu précédemment. La sortie 6 du basculeur 1.802 est cablée sur l'entrée 1 du circuit logique ET 1.805 qui reçoit le signal ALCA sur son entrée 2. La sortie 3 de cet outil ET actionne l'entrée d'horloge 4 des basculeurs 1.806 et 1.807. Le signal T1 quant à lui alimente l'entrée 1 de la porte logique OU inverseur 1.803 dont l'autre entrée 2 reçoit l'initialisation générale Z. La sortie 3 de ce circuit OU inverseur 1.803 attaque l'entrée continue 1 du basculeur 1.808, ce qui a pour but de mettre ce dernier dans l'état logique »un« sur sa sortie directe 5. La sortie 5 du basculeur 1.808 est reliée à l'entrée 2 du circuit ET 1.811 qui reçoit d'autre part sur son entrée 1 la sortie 6 du basculeur 1.806. Cette même sortie 6 du basculeur 1.806 est dirigée sous le nom FX vers le registre de Fonction. La sortie 3 de la porte logique ET 1.811 prend le nom AX à destination du Registre d'Adresse. Le circuit logique OU 1.812 reçoit sur son entrée 1 la sortie 5 du basculeur 1.807 connectée également sous le nom FV au Registre de Fonction; il reçoit sur son entrée 3 la sortie 6 du basculeur 1.808 et comme on l'a déjà vu sur son entrée 2, le signal SO. La sortie 4 du circuit OU logique 1.812 est dirigée sous le nom AV vers le Registre d'Adresse.

Le Générateur de Commande d'Assignation comporte par ailleurs les deux basculeurs 1.809 et 1.810. Le premier de ces basculeurs coté 1.809 est initialisé ou réinitialisé à »zéro« sur sa sortie complémentée 6 à l'aide de l'outil logique OU inverseur 1.804 dont la sortie 3 actionne l'entrée continue 1 de ce basculeur. La porte logique OU inverseur 1.804 reçoit elle-même sur son entrée 1 le signal FRA provenant du Générateur de Rafraîchissement Apparent et le signal général d'initialisation Z sur son entrée 2. Le même basculeur 1.809 est mis au travail, à la valeur logique »un« sur sa sortie complémentée 6 par application sur son entrée d'horloge 4 du signal BR2X1 provenant du Terminateur de Cycle ou par application sur son entrée continue 2 du signal BR1X1 issu du Générateur de Rafraîchissement Apparent. La sortie 6 du basculeur 1.809 communique son niveau logique »un« aux deux outils logiques OU 1.813 et 1.814 par câblage sur leur entrée 1. Les sorties 3 respectivement BRZ0 et BRZ1 sont destinées au Registre d'Adresse.

L'outil 1.813 reçoit en outre le signal Az sur son entrée 2 et l'outil 1.814, le signal Az sur l'entrée 2 homologue. Ces deux derniers signaux sont fournis par le Registre d'Adresse. Le basculeur 1.810 est initialisé ou réinitialisé par application sur son entrée continue 1 du signal SALZ provenant de l'Excitateur de Mémoire; il prend alors la valeur logique »zéro« sur sa sortie complémentée 6 dirigée sous le nom BAC sur le Registre d'Adresses. Il est mis au travail avec BAC à la valeur logique »un« par application sur son entrée d'horloge 4 du signal S2 en provenance du Sélecteur-Lanceur.

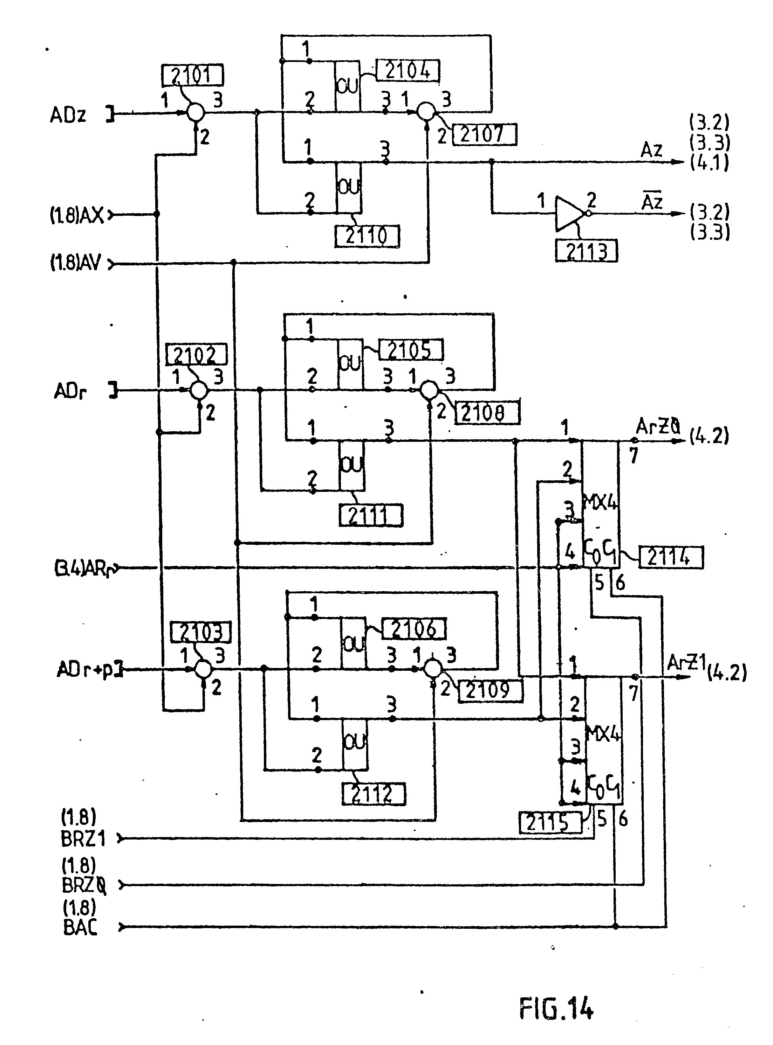

La figure 14 donne une représentation du Registre d'Adresse. Le registre d'adresse transforme les signaux d'adresses ADz, ADr ou ADr + p apparaissant sur l'interface en signaux de sélection pour les zones de mémoire. Il assure pour ce faire deux fonctions principales: une fonction de mémorisation exécutée dans un système original de verrous et une fonction de multiplexage entre les adresses effectives et les adresses de rafraîchissement notées $AR_r$ issues du Compteur d'Adresse de Rafraîchissement (3.4). Le Registre d'Adresse opère sous contrôle du Générateur de Commande d'Assignation (1.8) dont il reçoit les signaux de commande AX, AV, BRZ0, BRZ1 et BAC. Les signaux de sélection destinés aux zones de mémoire (4.2) sont notés $A_rZ0$ ou $A_rZ1$ suivant leurs zones d'affectation, zone 0 ou zone 1. Le signal Az et sa valeur complémentée Az alimente pour leur part, le Distributeur de Commande pour les Zones de Mémoire (4.1), le Générateur de Rafraîchissement Masqué (3.2) et l'Enregistreur de Rafraîchissement Masqué (3.3). L'indice z d'adresse est une valeur particulière du rang des chiffres binaires d'adresse dont le choix sera précisé plus loin. Les adresses d'indice r ou r + p correspondent aux chiffres binaires d'adresse à multiplexer entre eux pour entrer successivement au cours d'un même cycle dans les cellules de mémoire »MOS«. Ces mêmes chiffres binaires sont également à multiplexer avec les adresses de rafraîchissement.

Le nombre de chiffres binaires représenté par l'indice r ou l'indice r + p dépend du type de cellules »MOS« et en fait de sa capacité. A titre indicatif, une cellule »MOS« de 16K chiffres binaires fera appel à 7 adresses d'indices r et 7 adresses r + p, soit 14 chiffres binaires au total. Il y aura autant de cellules de mémorisation dont deux seulement sont représentées sur la figure 14, une pour l'indice r et une pour l'indice r + p. Ces cellules de mémorisation du registre d'adresses ainsi que celle qui enregistre l'adresse d'indice z se présentent toutes de la même manière. Un circuit ET, coté suivant le cas 2.101, 2.102, ou 2.103 conditionne l'adresse entrant en 1 en provenance de l'interface par le signal cablé en 2 assurant la commande de transfert AX. Un circuit OU 2.104, 2.105 ou 2.106 reçoit sur son entrée 2 la sortie 3 du précédent circuit ET. Il alimente par sa sortie 3 l'entrée 1 d'un autre circuit ET 2.107, 2.108 ou 2.109 conditionné sur son entrée 2 par le signal de commande de verrouillage AV. La sortie 3 de ces derniers circuits alimente l'entrée 1 du circuit OU précédent. Un second circuit OU coté 2.110, 2.111 ou 2.112 est monté en parallèle sur le premier; leurs entrées homologues 1 ou 2 sont reliées entre elles. Ainsi l'entrée 1 du circuit 2.110 est connectée à l'entrée 1 du circuit 2.104 et ainsi de suite. On assure ainsi au circuit de verrouillage constitué par des outils tels que le circuit OU 2.104 et le circuit ET 2.107 la rapidité maximale, les charges étant reportées sur l'outil OU en parallèle tel que 2.110.

La sortie 3 de l'outil OU logique 2.110 délivre directement le signal Az et alimente sur l'entrée 1 l'inverseur 2.113 qui produit sur sa sortie 2 le signal complémenté Az.

La sortie 3 des circuits OU 2.111 et 2.112 attaque respectivement d'une part l'entrée 1 des multiplexeurs quatre voies 2.114 et 2.115 et d'autre part, l'entrée 2 de ces mêmes multiplexeurs. Les entrées 3 et 4 de ces multiplexeurs reçoivent les signaux $AR_r$ d'Adresse de Rafraîchissement. Les entrées 1, 2, 3 et 4 des multiplexeurs sont des entrées de données. L'entrée de commande 5 (cotée $C_0$) reçoit respectivement les signaux BRZ0 et BRZ1, BRZ0 sur l'outil 2.114 affecté de la zone 0 et BRZ1 sur l'outil 2.115 propre à la zone 1. La commande (cotée $C_0$) BRZ0 ou BRZ1 fait commuter l'ensemble des entrées de données (1 et 2) sur l'ensemble des entrées de données (3 et 4) recevant toutes les deux l'adresse de rafraîchissement $AR_r$. La sortie 7 des multiplexeurs 2.114 et 2.115 délivre respectivement les signaux ArZ0 et ArZ1 correspondant aux zones Z0 et Z1 dans lesquelles ils opèrent. L'entrée de commande 6 (cotée $C_1$) des deux multiplexeurs 2.114 et 2.115 est affectée au signal commun BAC qui fait commuter les entrées de données 1 sur les entrées de données 2 de ces multiplexeurs.

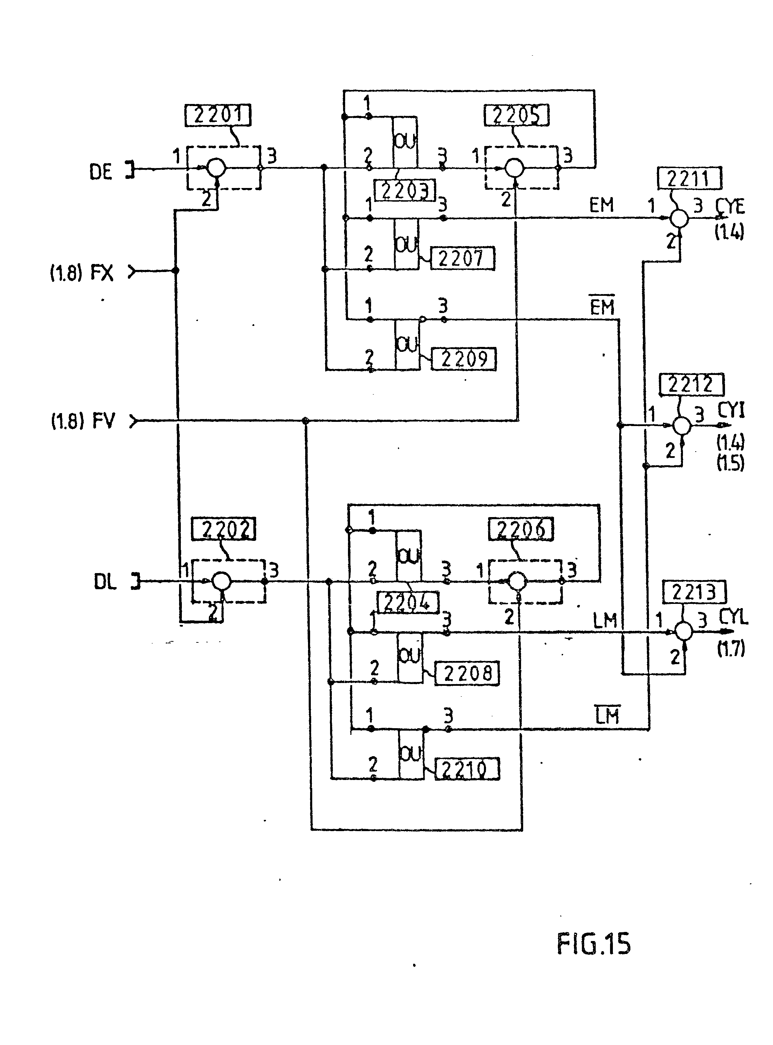

La figure 15 donne une représentation du Registre de Fonction. Le registre de fonction emmagasine les signaux d'ordre d'écriture (DE) et de lecture (DL) présentés par l'interface. Pour cela, il met en oeuvre des verrous de même type que ceux du registre d'adresses. Les verrous du registre de fonction opèrent sous le contrôle des signaux de commande FX et FV issus du générateur de commande d'assignation (1.8). A partir des valeurs emmagasinées le registre de fonction engendre en outre les signaux de condition CYE, CYI, CYL qui sont utilisés dans divers sous-organes du Régulateur de Commande du banc de mémoire.

Les signaux d'ordre d'écriture (DE) et de lecture (DL) issus de l'interface accèdent respectivement sur l'entrée 1 des circuits logiques ET 2.201 et 2.202. Ces deux circuits sont conditionnés sur leur entrée 2 par le signal de commande de transfert FX. La sortie 3 de ces mêmes circuits alimente respectivement l'entrée 2 des portes logiques OU 2.203 et 2.204. Ces dernières retransmettent, depuis leur sortie 3, la valeur reçue, sur l'entrée 1 des portes logiques ET respectives 2.205 et 2.206. Ces portes logiques ET sont elles-mêmes conditionnées sur leur entrée 2 par le signal de commande de verrouillage FV. Leur sortie 3 est raccordée en bouclage de retour sur l'entrée 1 des portes logiques OU précédentes respectivement, 2.203 et 2.204. Simultanément, les circuits logiques OU 2.207 et 2.208 ainsi que les outils logiques OU inverseur 2.209 et 2.210 sont montés en parallèle respectivement sur les portes logiques OU 2.203 et 2.204. Ainsi, les entrées 1 des trois circuits 2.203, 2.207 et 2.209 sont raccordées entre elles et il en est de même des entrées 2. La même disposition existe pour les trois circuits 2.204, 2.208 et 2.210. Cela permet de ne pas charger les dispositifs de verrouillage constitués des outils 2.203 et 2.205 ou des outils 2.204 et 2.206, leur assurant ainsi une vitesse maximale de commutation.

Les circuits logiques ET 2.211, 2.212 et 2.213 engendrant les signaux de condition sont alors câblés sur ces outils en parallèle. La porte logique ET 2.211 reçoit sur son entrée 1 l'ordre enregistré d'écriture issu de la sortie 3 du circuit OU 2.207 et sur son entrée 2 la valeur complémentée de l'ordre enregistré de lecture provenant de la sortie 3 du circuit OU inverseur 2.210. Elle produit sur sa sortie 3 le signal de condition de Cycle d'Ecriture CYE à destination du scripteur (1.4). La porte logique ET 2.212 recueille, sur son entrée 1, la valeur complémentée de l'ordre enregistré d'écriture fournie par la sortie 3 du circuit OU inverseur 2.209 ainsi que, sur son entrée 2, la valeur complémentée de l'ordre enregistre de lecture produit par la sortie 3 du circuit OU inverseur 2.210. Elle engendre sur sa sortie 3 le signal de condition de Cycle Indéfini CYI envoyé au scripteur (1.4) et au Régulateur d'Ecriture (1.5). Enfin, la porte logique ET 2.213 réalise l'intersection des signaux enregistrés de lecture et de non-écriture (valeur complémentée de celle d'écriture) issus de la sortie 3 respectivement du circuit OU logique 2.208 et du circuit OU logique inverseur 2.209. Elle reçoit ces signaux respectivement sur ses entrées 1 et 2. Elle délivre ainsi le signal de condition de Cycle de Lecture CYL à l'usage de Terminateur de Cycle (1.7).

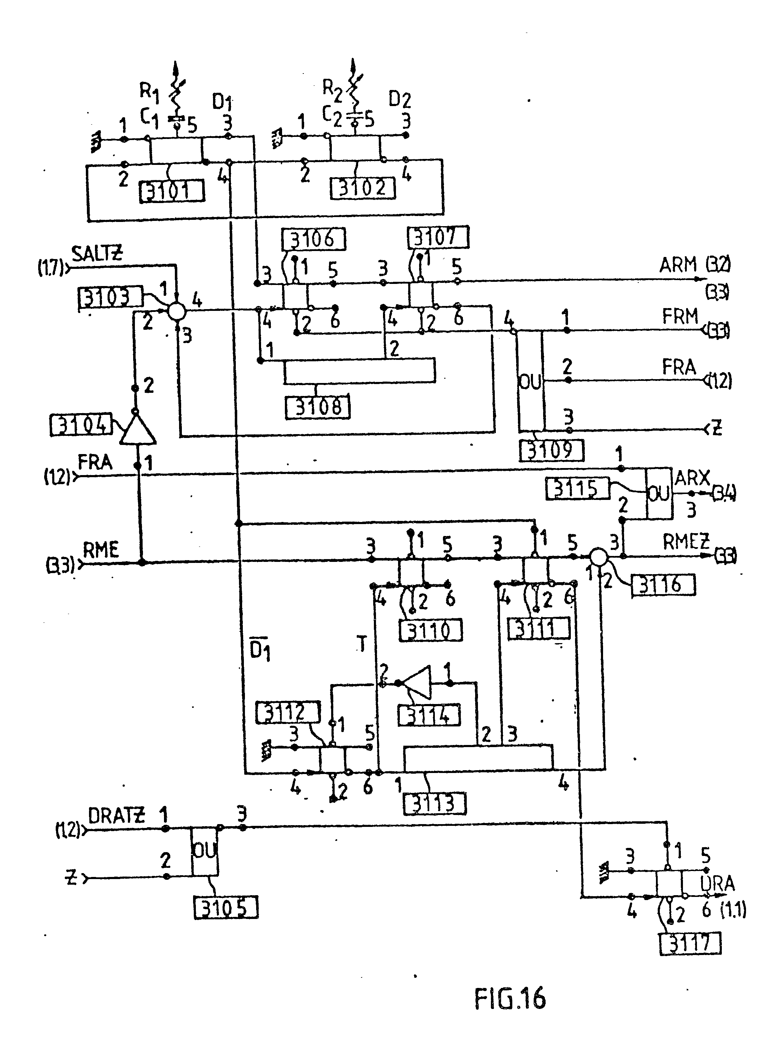

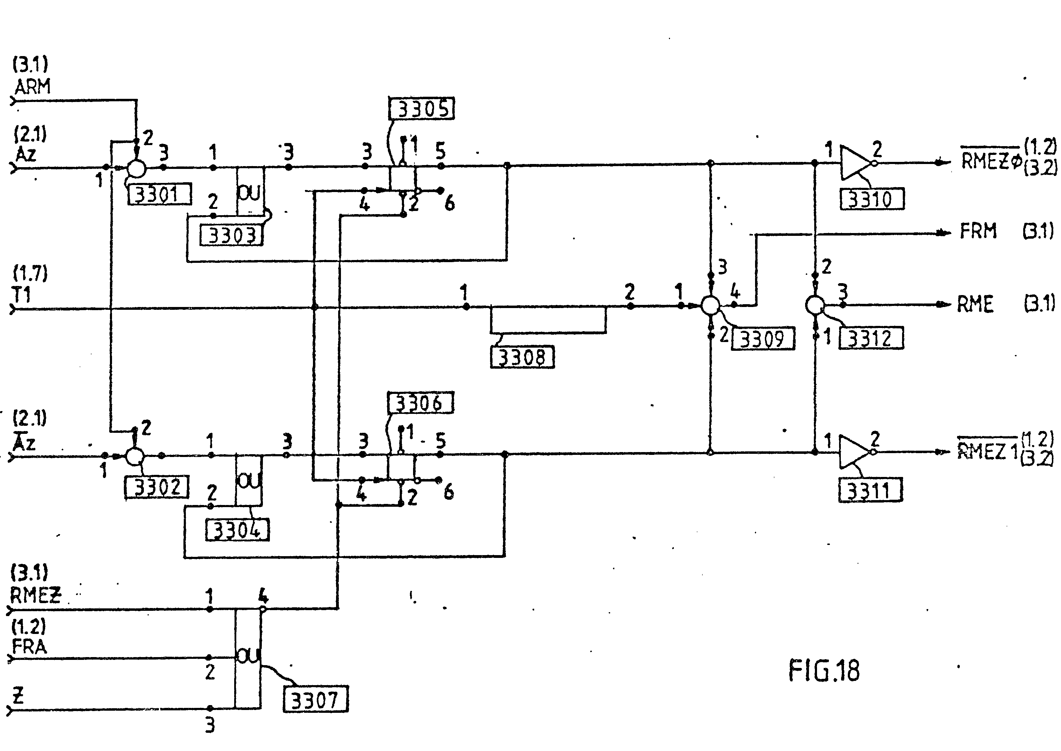

La figure 16 représente l'Excitateur de Rafraîchissement de la figure 4. Il comprend un générateur d'horloge composé des monostables 3.101 et 3.102 montés en multivibrateur et dont les durées de basculement sont réglables en fonction des deux constantes de temps $R_1 C_1$ et $R_2 C_2$ insérées dans chacun des circuits des deux monostables. Le monostable 3.101 délivre le signal $D_1$ à l'entrée 3 du basculeur 3.106. Ce signal $D_1$ est mémorisé par le basculeur 3.106 à l'arrivée sur son entrée 4 du signal délivré par la sortie 4 de la porte ET 3.103 qui reçoit, sur son entrée 1 le signal SALTZ émis par la sortie 5 de la porte OU 1.702 du terminateur de cycle, sur son entrée 2, le signal RME émis par la sortie 2 de l'inverseur 3.104 dont l'entrée 1 reçoit le signal RME émis par la sortie 3 de la porte ET 3.312 de la figure 18 signifiant qu'un rafraîchissement masqué a été exécuté, sur son entrée 3 le signal émis par la sortie 6 du basculeur 3.107. Le basculeur 3.107 est relié par son entrée 3 à la sortie 5 du basculeur 3.106, il recopie sur sa sortie 5 l'état du basculeur 3.106 lorsque le signal émis par la sortie de la porte ET 3.103 est transmis sur son entrée 4 au travers de la ligne à retard réglable 3.108. La sortie 5 du basculeur 3.107 délivre le signal ARM d'autorisation de rafraîchissement masqué vers l'entrée 1 de la porte ET 3.201 du générateur de rafraîchissement masqué et vers l'entrée 2 de la porte ET 3.301. Les entrées 2 des basculeurs 3.106 et 3.107 sont remises à zéro par la sortie 4 de la porte OU 3.109 qui reçoit, sur son entrée 1 le signal FRM de fin de rafraîchissement masqué émis par la sortie 4 de la porte ET 3.309 de l'enregistreur de rafraîchissement masqué, sur son entrée 2 le signal FRA de fin de rafraîchissement apparent émis par la sortie 2 de l'inverseur 1.209 du générateur de rafraîchissement apparent et sur son entrée 3 le signal Z d'initialisation générale. Le signal $D_1$ est émis par la sortie 4 du monostable 3.101 vers l'entrée d'horloge 4 du basculeur 3.112 dont l'entrée 3 est placée au potentiel de la masse.

La sortie 6 du basculeur 3.112 est reliée d'une part à l'entrée 1 de la ligne à retard réglable 3.113 et à l'entrée d'horloge 4 du basculeur 3.110. La ligne à retard 3.113 retransmet un instant plus tard, sur sa sortie 2 le signal qu'elle a reçue sur son entrée 1, vers l'entrée 1 de l'inverseur 3.114 dont la sortie 2 est reliée à l'entrée inverseuse 1 du basculeur 3.112. Ainsi le basculeur 3.112 est remis à zéro à l'arrivée du signal $D_1$ et repasse dans l'état 1 logique lorsque l'état pris par la sortie 6 du basculeur 3.112 a été recupéré sur la sortie 2 de la ligne à retard 3.113. Cet état est aussi transmis un instant plus tard par la sortie 3 de la ligne à retard vers l'entrée d'horloge 4 du basculeur 3.111 et un autre instant plus tard par la sortie 4 de la ligne à retard 3.113 vers l'entrée 2 de la porte ET 3.116. Le signal RME de rafraîchissement masqué exécuté appliqué à l'entrée 3 du basculeur 3.110 est ainsi successivement transmis sur les sorties 5 des basculeurs 3.110 et 3.111 montés en cascade. La sortie 5 du basculeur 3.111 est reliée à l'entrée 1 de la porte ET 3.116 qui émet ainsi sur sa sortie 3 le signal RMEZ de remise à zéro du signal de rafraîchissement masqué vers l'entrée 1 de la porte OU 3.307 de l'enregistreur de rafraîchissement masqué. Le signal RMEZ est aussi transmis à l'entrée 2 de la porte OU 3.115 dont l'autre entrée 1 reçoit le signal RFA de fin de rafraîchissement apparent émis par la sortie 2 de l'inverseur 1.209 du générateur de rafraîchissement apparent. La porte OU 3.115 engendre ainsi par sa sortie 3 le signal ARX d'ordre de commutation sur l'adresse de rafraîchissement lorsque le signal RMEZ est présent ou lorsque le signal FRA est émis par le générateur de rafraîchissement apparent. Le circuit »OU-NON« 3.105 reçoit sur son entrée 1 le signal DRATZ de temps de remise à zéro de rafraîchissement apparent émis par la sortie 3 du circuit OU 1.205 du générateur de rafraîchissement apparent et sur son entrée 2 le signal Z d'initialisation générale, sa sortie 3 est reliée à l'entrée 1 du basculeur 3.117.

La sortie 6 du basculeur 3.111 est reliée à l'entrée d'horloge 4 du basculeur 3.117. Le basculeur 3.117 est relié au potentiel de masse par son entrée 3 et émet sur sa sortie 6 le signal DRA vers l'entrée 1 de la porte ET 1.104 lorsque le basculeur 3.111 prend l'état 0 sur la sortie directe 5.

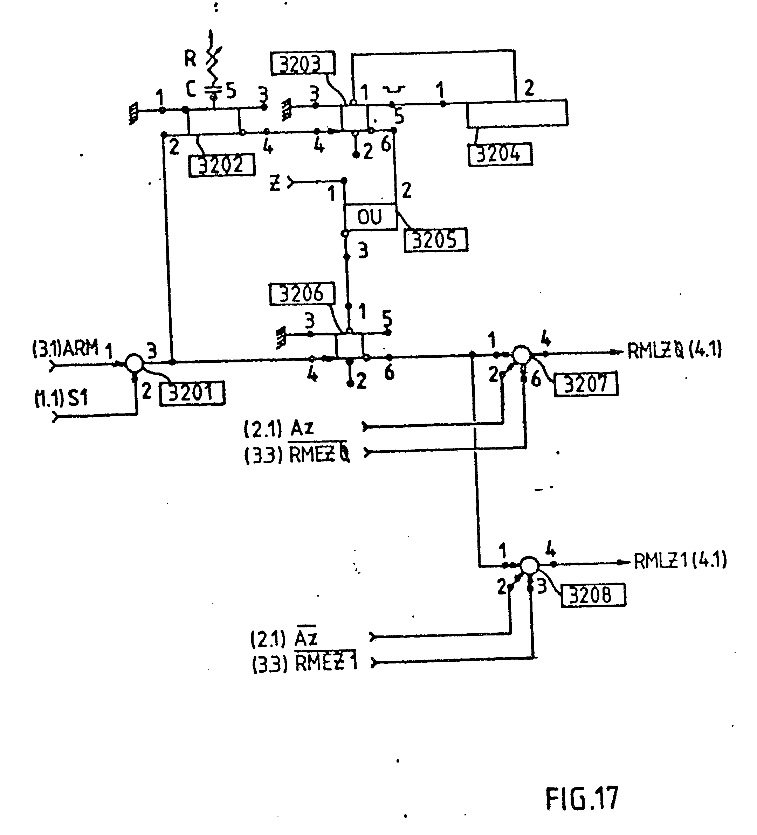

La figure 17 représente le générateur de Rafraîchissement Masqué. Il comprend un monostable 3.202 déclenché sur son entrée 2 par le signal apparaissant sur la sortie 3 de la porte ET 3.201 qui reçoit sur son entrée 1 le signal ARM d'autorisation de rafraîchissement masqué provenant de la sortie 5 du basculeur 3.107 de l'excitateur de rafraîchissement et sur son entrée 2 le signal S1 de synchronisation. La sortie 4 du monostable 3.202 est appliquée à l'entrée d'horloge 4 du basculeur 3.203 dont l'entrée 3 est reliée au potentiel de masse et dont la sortie 5 se trouve reliée à l'entrée 1 de la ligne à retard 3.204. La ligne à retard 3.204 est reliée sur sa sortie intermédiaire 2 à l'entrée 1 du basculeur 3.203. Au repos, le basculeur 3.203 est dans l'état 1 logique, il ne prend l'état 0 logique que durant le temps de transmission du front descendant du signal présent sur sa sortie 5 au travers de la ligne à retard 3.204.

La sortie 6 du basculeur 3.203 est reliée à l'entrée 2 du circuit logique »OU NON« 3.205 qui reçoit sur sa deuxième entrée 1 le signal Z général d'initialisation. La sortie 3 du circuit »OU NON« 3.205 est reliée à l'entrée 1 du basculeur 3.206 qui reçoit sur son entrée d'horloge 4 le signal émis par la sortie 3 de la porte »ET« 3.201. La sortie 6 du basculeur 3.206 est reliée, d'une part à l'entrée 1 de la porte ET 3.207 et d'autre part à l'entrée 1 de la porte ET 3.208, elle prend l'état 1 logique lorsqu'un signal est transmis par la sortie 3 de la porte ET 3.201. La porte ET 3.207 reçoit sur son entrée 2 le signal Az permettant de désigner une zone Z0 particulière du dispositif de mémorisation et sur son entrée 2 le signal RMEZ0 signalant qu'un rafraîchissement masqué n'est pas exécuté dans la zone Z0, elle émet sur sa sortie 4 le signal RMLZ0 à destination de la porte OU 4.108 du distributeur de commande pour les zones de mémoire pour lancer un rafraîchissement masqué en zone 0. De même, la porte ET 3.208 reçoit sur son entrée 2 le signal Az pour désigner une zone Z1 du dispositif de mémorisation et sur son entrée 3 le signal RMEZ1 signalant qu'un rafraîchissement masqué n'est pas exécuté en zone 1, elle émet sur sa sortie 4 le signal RMLZ1 à destination de l'entrée 2 du circuit OU 4.109 du distributeur de commande pour les zones de mémoire pour lancer un rafraîchissement masqué dans la zone 1.

La figure 18 représente l'Enregistreur de Rafraîchissement Masqué qui a pour but de contrôler l'exécution des cycles de rafraîchissement masqué dans le sous-ensemble de mémorisation. Il se compose principalement des basculeurs 3.305 — 3.306 et de la ligne à retard 3.308.

Les entrées d'horloge 4 des basculeurs 3.305 et 3.306 reçoivent le signal T1 émis par la ligne à retard 1.705 du terminateur de cycle. Ce signal T1 est également transmis à l'entrée 1 de la ligne à retard 3.308 dont la sortie 2 est reliée à l'entrée 1 de la porte ET 3.309. L'entrée 3 du basculeur 3.305 est reliée à la sortie 3 du circuit OU 3.303 dont l'entrée 1 est reliée à la sortie 3 de la porte ET 3.301 et l'entrée 2 à la sortie 5 du basculeur 3.305. La porte ET 3.301 reçoit, sur son entrée 2 le signal ARM d'autorisation de rafraîchissement masqué émis par la sortie 5 du basculeur 3.107 de l'excitateur de rafraîchissement et sur son entrée 1 le signal Az permettant l'adressage de la zone 1 de l'ensemble de mémorisation. De même l'entrée 3 du basculeur 3.306 est reliée à la sortie 3 du circuit OU 3.304 qui reçoit sur son entrée 1 le signal émis par la sortie 3 de la porte ET 3.302 et sur son entrée 2 le signal émis par la sortie 5 du basculeur 3.306. La porte ET 3.302 reçoit sur son entrée 1 le signal Az permettant l'adressage de la zone 0 de l'ensemble de mémorisation et sur son entrée 2 le signal ARM d'autorisation de rafraîchissement masqué. Les entrées 2 des basculeurs 3.305 et 3.306 sont commandées par la sortie 4 de la porte OU inverseur 3.307 qui reçoit, sur son entrée 1 le signal RMEZ de remise à zéro du signal de rafraîchissement masqué exécuté émis par la sortie 3 de la porte ET 3.116 de l'excitateur de rafraîchissement, sur son entrée 2 le signal FRA de fin de rafraîchissement apparent émis par la sortie 2 de l'inverseur 1.209 du générateur de rafraîchissement apparent et sur son entrée 3 le signal Z d'initialisation général. La porte ET 3.309 est reliée par son entrée 3 à la sortie 5 du basculeur 3.305 et par son entrée 2 à la sortie 5 du basculeur 3.306, elle délivre sur sa sortie 4 le signal FRM de fin de rafraîchissement masqué à destination de l'entrée 1 de la porte »OU-NON« 3.109 de l'excitateur de rafraîchissement. La porte ET 3.312 est reliée par son entrée 1 à la sortie 5 du basculeur 3.306 et par son entrée 2 à la sortie 5 du basculeur 3.305, elle transmet sur sa sortie 3 le signal RME de rafraîchissement masqué exécuté à l'entrée de l'excitateur de rafraîchissement. Les états des sorties 5 des basculeurs 3.305 et 3.306 sont inversés au travers des inverseurs 3.310 et 3.311 qui transmettent respectivement le signal RMEZ0 vers l'entrée 2 de la porte ET 1.211 et le signal RMEZ1 vers l'entrée 2 de la porte ET 1.212 du générateur de rafraîchissement apparent.

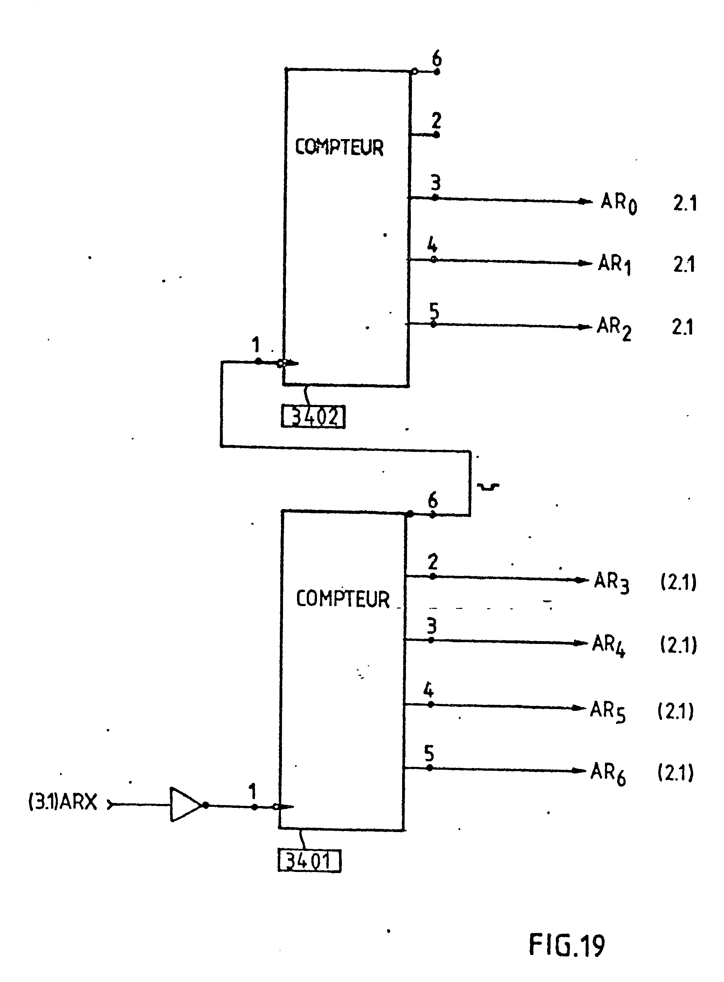

La figure 19 représente le Compteur d'Adresse de Rafraîchissement qui fournit l'adresse de rafraîchissement AR au registre d'adresse sous contrôle du signal de progression ARX issu de l'excitateur de rafraîchissement. Il se compose de deux compteurs 3.401 et 3.402 reliés en série. La sortie 6 du compteur 3.401 étant reliée à l'entrée 1 du compteur 3.402. Les bits de l'adresse de rafraîchissement $AR_0$ à $AR_2$

apparaissent respectivement sur les sorties 3, 4, 5 du compteur 3.402 (poids forts) alors que les bits de rafraîchissement $AR_3$ à $AR_6$ apparaissent respectivement sur les sorties 2, 3, 4, 5 du compteur 3.401.

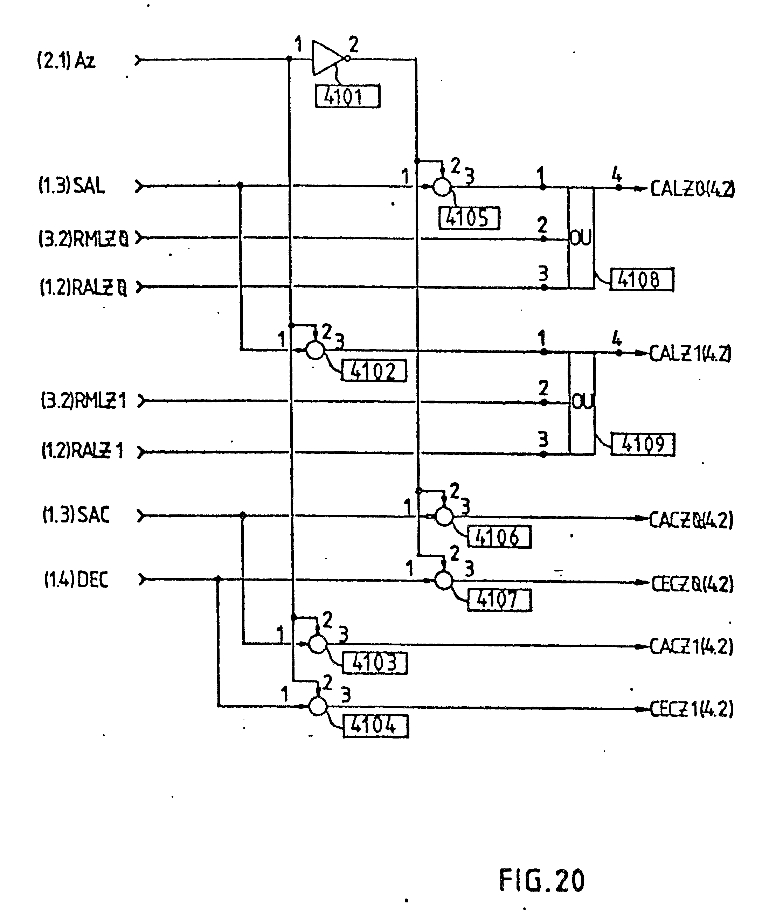

La figure 20 représente le Distributeur de Commandes pour les Zones de Mémoire. Il est constitué principalement des circuits OU 4.108 et 4.109 ainsi que des circuits ET 4.106, 4.107, 4.103 et 4.104.

L'entrée 1 du circuit OU 4.108 est reliée à la sortie 3 de la porte ET 4.105 qui reçoit sur son entrée 1 le signal SAL de sélection d'adresse ligne en provenance de la sortie 5 du basculeur 1.302 de l'excitateur de mémoire et sur son entrée 2 le signal provenant de l'inverseur 4.101 dont l'entrée est excitée par le signal Az de sélection de la zone 1 de la mémoire. L'entrée 2 du circuit OU 4.108 reçoit le signal RMLZ0 émis par la sortie 4 de la porte ET 3.207 du générateur de rafraîchissement masqué. L'entrée 3 de la porte Ou 4.108 reçoit le signal RALZ0 provenant du générateur de rafraîchissement apparent et signifiant qu'un rafraîchissement apparent a été lancé en zone 0. La sortie 4 de la porte OU 4.108 délivre le signal CALZ0 à destination du sous-ensemble des zones de mémoire pour commander l'adresse ligne en zone 0. Le circuit OU 4.109 est relié par son entrée 1 à la sortie 3 de la porte ET 4.102. Celle-ci reçoit le signal SAL sur son entrée 1 et le signal Az sur son entrée 2. L'entrée 2 du circuit 4.109 reçoit le signal RMLZ1 de rafraîchissement masqué lancé en zone 1 de la mémoire provenant du générateur de rafraîchissement. l'entrée 3 du circuit 4.109 reçoit le signal RALZ1 de rafraîchissement apparent lancé en zone 1 de la mémoire et provenant du générateur de rafraîchissement apparent. Le circuit OU 4.109 délivre sur sa sortie 4 le signal CALZ1 de commande de sélection de l'adresse ligne de la zone 1 de la mémoire, ce signal est transmis au sous-ensemble de mémorisation.

La porte ET 4.106 reçoit sur son entrée 1 le signal SAC de sélection d'adresse colonne émis par la sortie 5 du basculeur 1.306 de l'excitateur de mémoire et sur son entrée 2 le signal émis par l'inverseur 4.101 transmettant le signal Az. La sortie 3 de la porte ET 4.106 transmet alors le signal CACZ0 de commande de sélection d'adresse colonne de zone 0 au sous-ensemble des zones de mémoire. La porte ET 4.107 reçoit, sur son entrée 1 le signal de commande d'écriture transmis par la sortie 5 du basculeur 1.414 et sur son entrée 2 le signal Az. La sortie 3 de la porte ET 4.107 transmet la commande d'écriture en zone 0 CECZ0 au sous-ensemble des zones de mémoire. La porte ET 4.103 est alimentée par le signal SAC sur son entrée 1 et par l'adresse Az sur son entrée 2. La sortie 3 de la porte ET 4.103 transmet le signal CACZ1 de commande de la sélection d'adresse colonne en zone 1 au sous-ensemble des zones de mémoire. La porte ET 4.104 reçoit sur son entrée 1 le signal DEC et sur son entrée 2 le signal Az, elle transmet sur sa sortie 3 le signal CECZ1 de commande d'écriture en zone 1 au sous-ensemble de mémoire.

La figure 21 représente le Sous-Ensemble des Zones de Mémoire. Il est composé des blocs de mémorisation 4.210 et 4.211 représentant respectivement les zones $Z_0$ et $Z_1$. Le bloc 4.210 reçoit sur son entrée 1 un bit de donnée Dq transmis par la sortie 2 de l'inverseur 4.201 et sur ses entrées 2 à 8 les bits d'adresse de la zone 0, $Ar_1Z0$ à $Ar_7Z0$ transmis par le registre d'adresse.

Les entrées 9, 10, 11 sont connectées aux sorties respectives des inverseurs 4.203 à 4.205 transmettant les signaux CALZ0 de commande d'adresse ligne, CACZ0 de commande d'adresse colonne et CECZ0 de commande d'écriture transmis par le distributeur de commande des zones de mémoire. Le bloc 4.211 reçoit également sur son entrée 1 le bit de donnée Dq transmis par la sortie 2 de l'inverseur 4.201 et sur ses entrées 2 à 8 les bits d'adresse de la zone 1, $Ar_1Z1$, à $Ar_7Z1$ transmis par le registre d'adresse. Les entrées 9, 10, 11 sont connectées aux sorties respectives des inverseurs 4.207 à 4.209 transmettant les signaux CALZ1 de commande d'adresse ligne CACZ1 de commande d'adresse colonne, CECZ1 de commande d'écriture provenant du distributeur de commande des zones de mémoire.

On notera que plusieurs blocs de mémoire tels que 4.210 et 4.211 sont utilisés en parallèle pour mémoriser d'autres bits d'informations tels que Dq; ces blocs sont commandés et adressés par les mêmes circuits que ceux précédemment décrits.

Le fonctionnement du séquenceur de rafraîchissement dans l'ensemble du banc de mémoire qui vient d'être décrit est le suivant:

C'est au niveau du Sélecteur-Lanceur que s'effectue la phase de sélection qui se situe, (comme nous l'avons vu précédemment) au début de chaque cycle. Ainsi que le montre la figure 6, les demandes de Cycle utile DC ou DES d'une part et la demande de rafraîchissement DRA sont resynchronisées mutuellement par l'ensemble du dispositif constitué par les outils cotés 1.101 à 1.111. Le résultat de la sélection est donné par l'état des deux basculeurs 1.110 et 1.111. La sortie directe du basculeur 1.110 notée C indique une sélection de cycle utile, celle du basculeur 1.111 notée R, une sélection de rafraîchissement. En fait, les combinaisons d'état de ces deux basculeurs définissent la Sélection Ternaire décrite plus haut. Les valeurs logiques de sortie C, C et R de ces deux basculeurs conditionnent, à l'aide des circuits ET 1.112 à 1.114, les commandes de gestion des cycles en fonction du résultat de la sélection. Nous allons examiner successivement les trois cas de la Sélection Ternaire: tout d'abord, celui d'une sélection de »rafraîchissement« exclusif, (R seul à »un«) puis celui d'une sélection de »Cycle utile« exclusif (C seul à »un«) enfin celui d'une sélection simultanée de »Rafraîchissement« et de »Cycle utile« (C et R à »un«). Remarquons toutefois auparavant que la phase de sélection est systématiquement accompagnée du lancement d'une phase d'exécution de cycle utile. En effet, les signaux S1 et S4 issus des sorties 5 et 8 de la ligne à retard 1.107 sur la figure 6 déclenchent respectivement les basculeurs 1.302 et 1.306 de l'Excitateur de Mémoire sur la figure 8. Les opérations technologiques de Sélections d'Adresses de lignes »SAL« puis d'adresses de colonnes »SAC« sont donc mises en oeuvre a priori sans connaître le résultat de la sélection. Elles constituent la première partie de la phase d'exécution d'un cycle utile (ou »phase utile«) qui, ainsi anticipée, permet les gains de débit et de réduction de temps d'accès à l'information explicités plus haut.

Si, maintenant, le résultat de la phase de sélection est un »Rafraîchissement« exclusif, les basculeurs 1.110 et 1.111 du Sélecteur-Lanceur (Figure 6) présentent la configuration logique CR. Seul, l'outil logique ET 1.114 du Sélecteur-Lanceur délivre donc une impulsion CR(S3) à destination du Générateur de Rafraîchissement Apparent (figure 7). Au niveau de ce sous-organe, cette impulsion CR(S3) déclenche le monostable 1.201. Le front arrière du signal de la sortie complémentée de ce monostable va remettre à zéro sous le nom SALX0 le basculeur 1.302 de sélection d'adresses de lignes situé au niveau de l'Excitateur de Mémoire (figure 8). Il s'agit là de l'annulation de la première action technologique lancée prématurément dans ce cas, comme s'il s'était agi d'un cycle utile. La constante de temps du monostable 1.201 (figure 7) est calibrée de façon à assurer une durée de cette action technologique la plus faible possible compatible avec les contraintes d'utilisation des circuits »MOS«. Le basculeur 1.202 et la ligne à retard 1.203 transforment le front arrière du signal SALX0 en une impulsion qui, transmise sous le BR1X1, excite les commandes de branchement sur les adresses de rafraîchissement BRZ0 et BRZ1 dans le générateur de commande d'Assignation (figure 13). Ces commandes sont exécutées par commutation des multiplexeurs 4 voies 2.114 et 2.115 dans le Registre d'Adresse de la figure 14. Cela constitue donc la préparation de la phase d'exécution de rafraîchissement qui va être lancée ultérieurement. Après un léger retard et une inversion, sous le nom SACX0, l'impulsion créée par l'ensemble des outils cotés 1.202 et 1.203 va remettre à »zéro« le basculeur 1.306 de la figure 8, annulant ainsi la deuxième action technologique lancée prématurément, à savoir, la Sélection d'Adresses de Colonnes (SAC). Après un retard supplémentaire et également une inversion, la même impulsion attaque l'outil OU 1.205 qui lui-même déclenche la phase de Rafraîchissement proprement dite en mettant au travail le basculeur 1.210. Ce dernier lance en effet les opérations technologiques de rafraîchissement dans les zones de mémoire sous les noms RALZ0 et RALZ1. La demande de rafraîchissement DRA peut être annulée par le signal DRATZ agissant sur le basculeur 3.117 de cette demande dans l'Excitateur de Rafraîchissement (figure 16).

L'ensemble du dispositif constitué par le monostable 1.206, le basculeur 1.207, la ligne à retard 1.208 et l'inverseur 1.209 assure la création de l'impulsion FRA. Le front arrière du signal à durée calibrée de la sortie complémentée du monostable 1.206 est transformée en impulsion par le montage basculeur ligne à retard 1.207 et 1.208. Le signal FRA provoque la fin de cycle par déclenchement du Terminateur de Cycle, lequel, d'une part renvoie l'impulsion SALZ pour remettre à »zéro« le basculeur 1.210 et annuler ainsi l'action technologique de Rafraîchissement et d'autre part, réarme le Sélecteur-Lanceur pour un nouveau cycle par action du signal VAX1.

Examinons maintenant le cas où, dans le Sélecteur-Lanceur de la figure 6, le basculeur C (1.110) est au travail à l'issue de la phase de Sélection. L'outil logique ET 1.113 délivre alors l'impulsion C(S3). Celle-ci va animer le Régulateur d'Ecriture (figure 10) ou le Lecteur (figure 11) ou les deux suivant l'état des signaux CYE, CYI, CYL du registre de Fonction (figure 15). Quel que soit cet état, l'exécution du cycle utile est poursuivie à bonne fin; un nouveau cycle pourra repartir. Dans le cas où simultanément le basculeur R (1.111) était à »zéro«, on vient de décrire le déroulement d'un »cycle utile exclusif«, si par contre ce basculeur est à »un« nous sommes dans le troisième cas de la Sélection Ternaire, qui va faire l'objet du paragraphe suivant. Cependant, quelle que soit la valeur logique de l'état du basculeur R, la mise au travail du basculeur C a conduit à l'achèvement de la phase d'exécution de Cycle Utile, exécution qui avait été commencée dès la début de cycle pour obtenir un gain de performance sur le temps de cycle et sur le temps d'accès à l'information.

Si enfin, simultanément à la mise à »un« du basculeur C (1.110), le basculeur R (1.111) est lui aussi au travail à l'issue de la phase de sélection, le déroulement du cycle noté (C, R) s'exécute de la manière suivante. Parallèlement à l'achèvement de la phase d'exécution de cycle utile déclenché par l'impulsion C(S3); l'outil ET 1.112 du Sélecteur-Lanceur (Figure 6) engendre l'impulsion CR(S3) puisque les conditions logiques C et R le permettent. Cette impulsion CR(S3) met au travail le basculeur 1.708 du Terminateur de Cycle (Figure 12). Il apparaît ainsi un signal à »zéro« sur la sortie directe 5 et un signal à »un« sur la sortie complémentée 6 de ce basculeur. Par suite, lorsqu'en fin de phase d'exécution de cycle utile, le Terminateur de Cycle est ébranlé, l'outil logique ET 1.710 est inhibé par la sortie 5 du basculeur 1.708 et le signal de réarmement VAX1 n'est pas délivré. L'organe de commandes n'est pas libéré pour un nouveau cycle. Au contraire, l'outil ET 1.711 est validé par la sortie 6 du basculeur 1.708 et le signal LRA est émis à destination du Générateur de Rafraîchissement Apparent (figure 7). Là, il déclenche sur l'outil OU 1.205 l'exécution d'un Rafraîchissement par application de la procédure décrite plus haut pour la phase d'exécution d'un »Rafraîchissement« exclusif. La commutation sur les adresses de rafraîchissement aura été assurée auparavant dans le Terminateur de Cycle par la création de l'impulsion BR2X1 sur l'outil ET 1.709 validé par la sortie 6 du basculeur 1.708. A la fin de l'exécution du Rafraîchissement, le signal FRA est émis par le Générateur de Rafraîchissement pour exciter le Terminateur de cycle. Là, avant toute chose, il remet le basculeur 1.708 dans son état de repos, à »un« sur la sortie directe 5, et à »zéro« sur la sortie 6. Cela aura pour effet cette fois de laisser filtrer l'impulsion de réarmement VAX1, ce qui achève le cycle mixte (C, R) par préparation du Sélecteur-Lanceur pour un nouveau cycle. Bien sûr, au cours de ce deuxième passage, dans le Terminateur de Cycle, les signaux BR2X1 et LRA ne sont pas émis puisque invalidés par la sortie 6 à »zéro« du basculeur 1.708. On a ainsi mis en oeuvre l'enchaînement des exécutions d'une phase utile et d'un Rafraîchissement dans un même cycle, minimisant ainsi les pertes de temps de la servitude technologique de Rafraîchissement.

Remarquons que le phase utile se déroule toujours en tête de cycle avec les conséquences heureuses que l'on a vu pour le temps d'accès à l'information. Par contre, une demande de Rafraîchissement n'est jamais mise en attente au-delà du temps d'exécution de cette phase utile, ce qui est également important du point de vue de la contrainte technologique.

Il découle de l'exposé qui vient d'être fait d'une réalisation préférée de l'invention que les performances sont sensiblement améliorées en débit et en accessibilité à l'information tout en satisfaisant les contraintes technologiques propres aux circuits »MOS«.

## Revendications

1. Procédé de rafraîchissement d'un banc de mémoire à cellules capacitives d'un système de traitement de l'information dans lequel les opérations normales d'écriture ou de lecture d'informations dans le banc de mémoire et les opérations de rafraîchissement ont lieu durant des intervalles de temps déterminés, l'exécution de ces opérations occupant respectivement des cycles utiles ou de rafraîchissement du système de traitement de l'information, chaque cycle étant constitué d'une phase de sélection (1) d'une part du type d'opération que le système désire effectuer à l'intérieur du banc de mémoire, d'autre part, des cellules du banc de mémoire concerné, et d'une phase d'exécution (2) du type d'opération sélectionné, caractérisé en ce qu'il consiste à lancer simultanément les phases de sélection (1) et d'exécution (2) d'un cycle utile (C), au début de chaque cycle puis à arrêter à la fin de la phase de sélection (1) l'exécution du cycle utile (C) et à enchaîner sur la phase d'exécution d'un cycle de rafraîchissement (R) si durant la phase de sélection (1) une opération de rafraîchissement (3) a été sélectionnée.

2. Procédé de rafraîchissement d'un banc de mémoire à cellules capacitives d'un système de traitement de l'information selon la revendication 1, caractérisé en ce qu'il consiste à lancer simultanément les phases de sélection (1) et d'exécution (2) au début de chaque cycle utile (C) puis à exécuter le cycle utile et enfin à enchaîner sur la phase d'exécution d'un cycle de rafraîchissement (R) si durant l'exécution du cycle utile (C) une opération de rafraîchissement (3) a été sélectionnée.

3. Séquenceur de rafraîchissement pour banc de mémoire à cellules capacitives d'un système de traitement de l'information dans lequel les opérations normales d'écriture ou de lecture des informations dans le banc de mémoire et les opérations de rafraîchissement ont lieu durant des intervalles de temps déterminés, l'exécution de ces opérations occupant respectivement des cycles utiles ou de rafraîchissement du système de traitement de l'information, chaque cycle étant constitué d'une phase de sélection, d'une part du type d'opération que le système désire effecteur à l'intérieur du banc de mémoire, d'autre part des cellules du banc de mémoire concerné et d'une phase d'exécution du type d'opération sélectionné; le banc de mémoire étant composé d'une part d'un sous-ensemble de mémorisation (4) associé à un régulateur de commande (1) et à un registre d'assignation (2), d'autre part d'un régulateur de rafraîchissement (3) associé au registre d'assignation (2) et au régulateur de commande (1) caractérisé en ce qu'il comprend: des premiers moyens (1101 à 1105) pour lancer simultanément les phases de sélection et d'exécution d'un cycle utile au début de chaque cycle; des deuxièmes moyens (1107 à 1115) pour sélectionner les cyles utiles et de rafraîchissement; des troisièmes moyens (1201 à 1209) pour arrêter à la fin de la phase de sélection l'exécution d'un cycle utile et pour enchaîner sur la phase d'exécution d'un cycle de rafraîchissement si durant la phase de sélection une opération de rafraîchissement a été sélectionnée par lesdits deuxièmes moyens.

4. Séquenceur de rafraîchissement pour banc de mémoire à cellules capacitives d'un système de traitement de l'information selon la revendication 3, caractérisé en ce qu'il comprend un quatrième moyen (1708 à 1711) permettant l'enchaînement direct de la phase d'exécution d'un cycle de rafraîchissement après exécution du cycle utile si durant l'exécution du cycle utile une opération de rafraîchissement a été sélectionnée.

## Patentansprüche

1. Verfahren zur Auffrischung einer Speicherbank mit kapazitiven Speicherzellen in einem Informationsverarbeitungssystem, bei dem die normalen Operationen des Einschreibens oder Auslesens von Informationen in der Speicherbank und die Auffrischoperationen während bestimmter Zeitintervalle erfolgen, wobei die Ausführung dieser Operationen Nutzzyklen bzw. Auffrischzyklen des Informationsverarbeitungssystems einnehmen und jeder Zyklus gebildet ist aus einer Phase zur Selektion (1) einerseits des Operationstyps, welchen das System in der Speicherbank ausführen will, und andererseits der Speicherzellen der betroffenen Speicherbank, und aus einer Ausführungsphase (2) zur Ausführung des ausgewählten Operationstyps, dadurch gekennzeichnet, daß es darin besteht, gleichzeitig die Phasen der Selektion (1) und der Ausführung (2) eines Nutzzyklus (C) zu Beginn eines jeden Zyklus einzuleiten und am Ende der Selektionsphase (1) die Ausführung des Nutzzyklus (C) zu beenden und an die Ausführungsphase eines Auffrischzyklus (R) anzuschließen, wenn während der Selektionsphase (1) eine Auffrischoperation (3) ausgewählt wurde.

2. Verfahren zur Auffrischung einer Speicherbank mit kapazitiven Speicherzellen in einem Informationsverarbeitungssystem, nach Anspruch 1, dadurch gekennzeichnet, daß es darin besteht, gleichzeitig die Phasen der Selektion (1) und der Ausführung (2) zu Beginn eines jeden Nutzzyklus (C) einzuleiten und den Nutzzyklus anschließend auszuführen sowie schließlich an die Phase der Ausführung eines Auffrischzyklus (R) anzuschließen, wenn während der Ausführung des Nutzzyklus (C) eine Auffrischoperation (3) ausgewählt wurde.

3. Sequenzer für die Auffrischung einer Speicherbank mit kapazitiven Speicherzellen in einem Informationsverarbeitungssystem, in welchem die normalen Operationen des Einschreibens oder des Auslesens von Informationen in der Speicherbank sowie die Auffrischoperationen während bestimmter Zeitintervalle stattfinden, wobei die Ausführung dieser Operationen Nutz- bzw. Auffrischzyklen des Informationsverarbeitungssystems einnehmen und jeder Zyklus gebildet ist aus einer Phase der Selektion einerseits des Operationstyps, den das System im Inneren der Speicherbank ausführen will, und andererseits der Speicherzellen der betroffenen Speicherbank, und aus einer Phase der Ausführung des gewählten Operationstyps; wobei die Speicherbank zum einen aus einer Speicher-Untergruppe (4), die einem Steuerregler (1) und einem Zuordnungsregister (2) zugeordnet ist, und andererseits aus einem Auffrischregler (3), der dem Zuordnungsregister (2) und dem Steuerregler (1) zugeordnet ist, zusammengesetzt ist, dadurch gekennzeichnet, daß er umfaßt: erste Mittel (1101 bis 1105) zum gleichzeitigen Einleiten der Phasen der Selektion und Ausführung eines Nutzzyklus zu Beginn eines jeden Zyklus; zweite Mittel (1107 bis 1115) zur Selektion der Nutz- und der Auffrischzyklen; dritte Mittel (1201 bis 1209) zum Anhalten der Ausführung eines Nutzzyklus am Ende der Selektionsphase und zum Anschließen an die Ausführungsphase eines Auffrischzyklus, wenn während der Selektionsphase eine Auffrischoperation durch die zweiten Mittel ausgewählt wurde.

4. Sequenzer zum Auffrischen einer Speicherbank mit kapazitiven Speicherzellen in einem Informationsverarbeitungssystem, nach Anspruch 3, dadurch gekennzeichnet, daß er vierte Mittel (1708 bis 1711) enthält, die das direkte Anschließen der Ausführungsphase eines Auffrischzyklus nach der Ausführung eines Nutzzyklus ermöglichen, wenn während der Ausführung des Nutzzyklus eine Auffrischoperation ausgewählt wurde.

**Claims**

1. Process for refreshing a capacitive cell memory bank of a data processing system in which the normal operations of writing or reading of data in the memory bank and the refreshing operations take place during determined time intervals, the execution of these operations occupying respectively useful cycles or refreshing cycles of the data processing system, each cycle consisting of a selection phase (1) on the one hand of the type of operation that the system desires to effect within the memory bank, on the other hand, of the cells of the memory bank concerned, and of an execution phase (2) of the type of operation selected, characterised in that it consists in simultaneously commencing the selection phase (1) and the execution phase (2) of a useful cycle (C), at the start of each cycle then in stopping at the end of the selection phase (1) the execution of the useful cycle (C) and in carrying on the execution phase of a refreshing cycle (R) if during the selection phase (1) a refreshing operation (3) has been selected.

2. Process for refreshing a capacitive cell memory bank of a data processing system according to claim 1, characterised in that it consists in starting simultaneously the selection phase (1) and the execution phase (2) at the start of each useful cycle (C) then in executing the useful cycle and finally in carrying on the execution phase of a refreshing cycle (R) if during the execution of the useful cycle (C) a refreshing operation (3) has been selected.

3. Sequencer for refreshing a capacitive cell memory bank of a data processing system in which the normal operations of writing or reading of the data in the memory bank and the refreshing operations take place during determined time intervals, the execution of these operations occupying respectively the useful cycles or the refreshing cycles of the data processing system, each cycle consisting of a selection phase, on the one hand of the type of operation that the system desires to carry out within the memory bank, on the other hand of the cells of the memory bank concerned, and of an execution phase of the type of operation selected, the memory bank being composed on the one hand of a memorizing sub-assembly (4) associated with a control regulator (1) and an assignment register (2), on the other hand with a refreshing regulator (3) associated with the assignment register (2) and with the control regulator (1), characterised in that it comprises: first means (1101 to 1105) for simultaneously commencing the selection phase and execution phase of a useful cycle at the start of each cycle, of second means (1107 to 1115) for selecting the useful cycles and refreshing cycles, of third means (1201 to 1209) for stopping at the end of the selection phase the execution of a useful cycle and for starting on the execution phase of a refreshing cycle if during the selection phase a refreshing operation has been selected by the said second means.

4. Sequencer for refreshing a capacitive cell memory bank of a data processing system according to claim 3, characterised in that it comprises a fourth means (1708 to 1711) enabling the direct carrying on of the execution phase of a refreshing cycle after execution of the useful cycle if during the execution of the useful cycle a refreshing operation has been selected.

FIG.1

FIG.2

FIG.3

FIG.4

FIG.5

FIG.6

FIG.7

FIG. 8

FIG. 9

0 033 673

FIG.10

FIG.11

FIG.12

FIG.13

0 033 673

FIG.14

FIG.15

FIG.16

FIG.17

FIG.18

FIG.19

FIG.20

FIG.21

FIG.22

FIG.23

|   | R |   |
|---|---|---|
|   | 0 | 1 |
| 0 |   | (R) |
| 1 | (C) | (C,R) |

C

FIG. 24

FIG. 25